# EUROPEAN PATENT APPLICATION

(11) **EP 4 848 947 A1**
(43) Date of publication of application: **02.12.2026**
(21) Application number: 26165723.3
(22) Date of filing: 18.03.2026
(51) Int. Cl.: H10F 39/00

(54) **IMAGE SENSOR INCLUDING A SEPARATION PATTERN HAVING OPEN PORTIONS AND HALF OPEN PORTIONS**

(30) Priority: 30.05.2025 KR 20250071436; 04.02.2026 KR 20260022842
(71) Applicant: Samsung Electronics Co., Ltd., Suwon-si, Gyeonggi-do 16677 (KR)
(72) Inventor: KIM, Hwanwoong, 16677 Suwon-si, Gyeonggi-do (KR); LEE, Hongsuk, 16677 Suwon-si, Gyeonggi-do (KR)
(74) Representative: Kuhnen & Wacker Patent- und Rechtsanwaltsbüro PartG mbB

(57) **Abstract**

An image sensor (100) including a substrate including photoelectric conversion regions, a separation pattern between the photoelectric conversion regions, and a transfer transistor and a floating diffusion region at each of the photoelectric conversion regions. The separation pattern surrounds edges of nine of the photoelectric conversion regions and defines a pixel region (PX). The separation pattern extending in first and second directions. Within the single pixel region (PX), the separation pattern includes first and second full open portions, spaced apart from the separation pattern in both the first and second directions, and includes first and second half open portions spaced apart from the separation pattern in one of the first and second directions. In open portions among the first and second full open portions, the first and second half open portions, floating diffusion regions extending in one or more of the photoelectric conversion regions are connected to each other.

## Description

### BACKGROUND

### 1. Field

The present inventive concepts relate to image sensors.

### 2. Description of the Related Art

The image sensor may be a semiconductor device that converts an optical image into an electrical signal. The image sensor may be classified as a CCD (Charge coupled device) type and a CMOS (Complementary metal oxide semiconductor) type. The CMOS type image sensor is abbreviated as CIS (CMOS image sensor). The CIS includes a plurality of pixels arranged in a two-dimensional manner. Each of the pixels may include a photodiode PD. The photodiode may convert incident light into an electrical signal.

### SUMMARY

The present inventive concepts provide image sensors capable of more effectively connecting a floating diffusion region and reducing parasitic capacitance.

An image sensor according to some example embodiments includes a substrate including photoelectric conversion regions, a separation pattern between the photoelectric conversion regions, and a transfer transistor and a floating diffusion region in each of the respective photoelectric conversion regions. The separation pattern surrounds the edge of nine of the photoelectric conversion regions in a plane and defines single pixel region. The separation pattern extends in a first direction in a plane and a second direction intersecting with the first direction. Within the single pixel region, the separation pattern includes a first full open portion and a second full open portion, in which the separation pattern is spaced apart in both the first direction and the second direction, and a first half open portion and a second half open portion, in which the separation pattern is spaced apart in one of the first direction or the second direction. In one or more of the first full open portion, the second full open portion, the first half open portion, and the second half open portion, floating diffusion regions are in one or more photoelectric conversion regions are connected to each other.

An image sensor according to some example embodiments may include a substrate including photoelectric conversion regions and a separation pattern between the photoelectric conversion regions, the separation pattern surrounding edges of nine of the photoelectric conversion regions in a plane to define single pixel region, the separation pattern extends in a plane in a first direction and in a second direction crossing the first direction, within the single pixel region the separation pattern including an open portion at a point where the separation pattern intersects in the first direction and the second direction, the open portion including a first full open portion and a second full open portion both spaced apart in the first direction and the second direction by the separation pattern, and a first half open portion and a second half open portion spaced apart in one of the first direction and the second direction by the separation pattern, and a ground voltage application pattern in at least one of the open portions among the open portions.

An image sensor according to some example embodiments may include a substrate including photoelectric conversion regions, and a separation pattern extend between the photoelectric conversion regions. The separation pattern may surround edges of nine of the photoelectric conversion regions in a plane and define single pixel region, and the separation pattern may be in a first direction in the plane and a second direction crossing the first direction. Within the single pixel region, the separation pattern may include open portions at points where the separation pattern crosses the first direction and the second direction. The open portions may include first to sixth sub open portions and first and second half open portions, wherein the first to third sub open portions may be disposed adjacent to each other in a region where four photoelectric conversion regions meet, and the fourth to sixth sub open portions may be disposed adjacent to each other in a region where four photoelectric conversion regions meet.

According to example embodiments, an image sensor may be provided that more effectively connects a floating diffusion region and reduces parasitic capacitance.

### BRIEF DESCRIPTION OF THE DRAWINGS

FIG. 1 is an example block diagram of an image sensor according to some example embodiments.
FIG. 2 is a circuit diagram of a pixel included in the image sensor according to some example embodiments of the present inventive concepts.
FIG. 3 illustrates a circuit diagram identical to FIG. 2 with respect to some example embodiments.
FIG. 4 shows the same or similar circuit diagram as FIG. 2 with respect to some example embodiments.
FIG. 5 schematically illustrates a planar arrangement of a plurality of pixels included in the image sensor.
FIG. 6 illustrates a planar arrangement of one pixel shown in FIG. 5.
FIG. 7 schematically illustrates the connection relationship of the floating diffusion region in the image sensor according to some example embodiments of FIG. 6.
FIG. 8 is a cross-sectional view of the image sensor of FIG. 6 taken along the line A-A'.
FIG. 9 is a cross-sectional view showing the image sensor of FIG. 6 cut along the line B-B'.
FIG. 10 illustrates some example embodiments of a pixel arrangement in a case where the separation pattern does not include an open portion.
FIG. 11 illustrates the same or similar region as FIG. 6 with respect to some example embodiments.
FIG. 12 illustrates the same or similar region as FIG. 6 for some example embodiments.
FIG. 13 illustrates the same or similar region as FIG. 12 with respect to some example embodiments.
FIG. 14 illustrates the same or similar region as FIG. 6 for some example embodiments.
FIG. 15 shows the same or similar region as FIG. 6 with respect to some example embodiments.
FIG. 16 illustrates the same or similar region as FIG. 15 with respect to some example embodiments.
FIG. 17 illustrates the same or similar region as FIG. 12 with respect to some example embodiments.
FIG. 18 illustrates the same or similar region as FIG. 6 for some example embodiments.
FIG. 19 is a cross-sectional view taken along the C-C' line of FIG. 18.
FIG. 20 illustrates the same or similar region as FIG. 18 for some example embodiments.
FIG. 21 illustrates the same or similar region as FIG. 20 with respect to some example embodiments.
FIG. 22 illustrates the same or similar region as FIG. 18 with respect to some example embodiments.
FIG. 23 illustrates the same or similar region as FIG. 18 with respect to some example embodiments.
FIG. 24 illustrates the same or similar region as FIG. 18 for some example embodiments.
FIG. 25 shows the same or similar region as FIG. 6 for some example embodiments.
FIG. 26 shows the same or similar region as FIG. 20 for some example embodiments.

### DETAILED DESCRIPTION

Hereinafter, various examples of the present inventive concepts will be described in detail with reference to the accompanying drawings so that those of ordinary skill in the art to which the present inventive concepts pertains may easily implement the present inventive concepts. The present inventive concepts may be implemented in various different forms and is not limited to some example embodiments described herein.

In order to clearly describe the present inventive concepts, portions not related to the description have been omitted, and throughout the entire specification, the same reference numerals are used for identical or similar elements.

In addition, the size and thickness of each component shown in the drawings are illustrated arbitrarily for convenience of explanation, and therefore, the present inventive concepts are not necessarily limited to those shown. In the drawings, the thicknesses are depicted as enlarged in order to clearly illustrate various layers and regions. And in the drawings, for convenience of explanation, the thicknesses of some layers and regions are exaggerated.

In addition, when a portion such as a layer, film, region, or plate is described as being on or above another portion, this includes not only the case where it is directly on the other portion, but also cases where there is another portion in between. Conversely, when any portion is described as being "on" another portion, it means that no other portion is present therebetween. In addition, stating that something is "on" or "above" a reference portion means that it is positioned above or below the reference portion, and does not necessarily mean that it is positioned "on" or "above" in the direction opposite to gravity.

Also, throughout the entire specification, when any portion is described as "including" any component, this means that, unless specifically stated otherwise, other components are not excluded, but rather, other components may be further included.

In addition, in the entire specification, the phrase "in plan view" refers to viewing the subject portion from above, and the phrase "in cross-sectional view" refers to viewing a cross section obtained by vertically cutting the subject portion from the side.

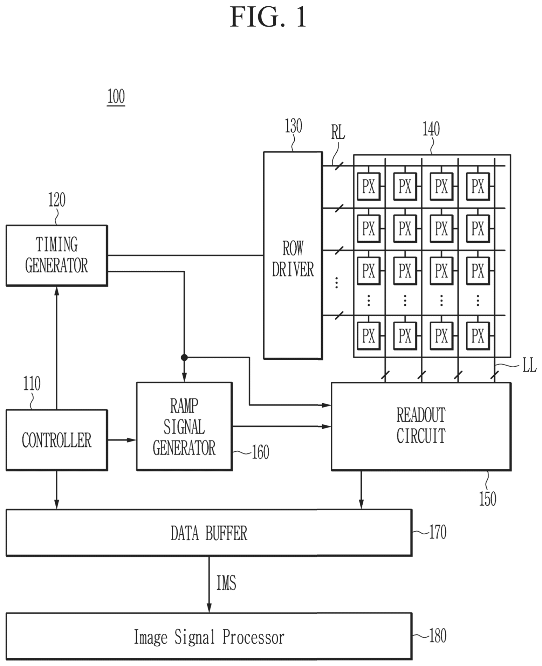

FIG. 1 is some example embodiments block diagram of an image sensor according to some example embodiments.

Referring to FIG. 1, an image sensor 100 according to some example embodiments may include a controller 110, a timing generator 120, a row driver 130, a pixel array 140, a readout circuit 150, a ramp signal generator 160, a data buffer 170, and an image signal processor 180. In some example embodiments, the image signal processor 180 may be positioned outside the image sensor 100.

The image sensor 100 may convert light received from the outside into an electrical signal to generate an image signal. The image signal IMS may be provided to the image signal processor 180.

The image sensor 100 may be mounted on an electronic device having an image or light sensing function. For example, the image sensor 100 may be mounted in electronic devices such as a camera, smartphone, wearable device, Internet of Things (IoT) device, home appliance, tablet PC (Personal Computer), PDA (Personal Digital Assistant), PMP (portable multimedia player), navigation, drone, and/or advanced driver assistance system (ADAS). Alternatively, the image sensor 100 may be mounted in an electronic device including vehicles, furniture, manufacturing facilities, doors, and/or various measurement instruments as a component.

The controller 110 may overall control each component 120, 130, 150, 160, 170 included in the image sensor 100. The controller 110 may control the operation timing of each of the components 120, 130, 150, 160, 170 using control signals. In some example embodiments, the controller 110 may receive a mode signal indicating an imaging mode from an application processor, and may control the image sensor 100 overall based on the received mode signal. For example, the application processor may determine the imaging mode of the image sensor 100 according to various scenarios such as the illuminance of the imaging environment, the user's resolution setting, and/or a sensed or learned state, and may provide the determined result to the controller 110 as a mode signal. The controller 110 may control the plurality of pixels of the pixel array 140 to output pixel signals according to the imaging mode, the pixel array 140 may output pixel signals for each of the plurality of pixels or pixel signals for some of the plurality of pixels, and the readout circuit 150 may sample and process the pixel signals received from the pixel array 140. The timing generator 120 may generate a signal serving as a reference for the operation timing of components of the image sensor 100. The timing generator 120 may control timing of the row driver 130, the readout circuit 150, and the ramp signal generator 160. The timing generator 120 may provide control signals controlling the timing of the row driver 130, the readout circuit 150, and the ramp signal generator 160.

The pixel array 140 may include a plurality of pixels PX, and a plurality of row lines RL and a plurality of column lines LL each connected to the plurality of pixels PX. In some example embodiments, each pixel PX may include at least one photoelectric conversion element. The photoelectric conversion element may detect incident light and convert the incident light into an electrical signal, that is, a plurality of analog pixel signals, according to the amount of light. The photoelectric conversion element may be a photodiode, a pinned diode, or the like. In addition, the photoelectric conversion element may be a SPAD (Single-Photon Avalanche Diode) applied to a 3D sensor pixel. The level of the analog pixel signal output from the photoelectric conversion element may be proportional to the amount of charge output from the photoelectric conversion element. That is, the level of the analog pixel signal output from the photoelectric conversion element may be determined according to the amount of light received into the pixel array 140.

A plurality of row lines RL extend in a first direction and may be connected to pixels PX arranged along the first direction. For example, a control signal output from the row driver 130 to the row line RL may be delivered to the gate of the transistor of a plurality of pixels PX connected to the row line RL. The column line LL extends in a second direction crossing the first direction and may be connected to the pixels PX disposed along the second direction. A plurality of pixel signals output from a plurality of pixels PX may be delivered to a readout circuit 150 through a plurality of column lines LL.

On the pixel array 140, a color filter layer and a microlens layer may be positioned. The microlens layer includes a plurality of microlenses, and each of the plurality of microlenses may be positioned above at least one corresponding pixel PX. The color filter layer includes color filters such as red, green, and blue, and may further include a white filter, however, other colors may be used. For one pixel PX, a color filter of one color may be positioned between the pixel PX and a microlens corresponding to the pixel PX. Alternatively, one color filter may be positioned in a plurality of pixels PX absorbing the same or similar color.

The row driver 130 may generate a control signal for driving the pixel array 140 in response to a control signal of the timing generator 120, and may provide the control signal to a plurality of pixels PX of the pixel array 140 through a plurality of row lines RL. In some example embodiments, the row driver 130 may control such that the pixel PX detects light incident in units of row lines. The row line unit may include at least one row line RL. For example, the row driver 130 may provide transmission signals, reset signals, selection signals, and the like to the pixel array 140, as will be described below.

The readout circuit 150 may convert a pixel signal (or electrical signal) from the pixels PX connected to a selected row line RL among the plurality of pixels PX, in response to a control signal from the timing generator 120, into a pixel value indicating the light quantity. The readout circuit 150 may convert a pixel signal output through a corresponding column line LL into a pixel value. For example, the readout circuit 150 may convert the pixel signal into a pixel value by comparing the ramp signal and the pixel signal. The pixel value may be image data having a plurality of bits. For example, the readout circuit 150 may include a selector, a plurality of comparators, and a plurality of counter circuits, and the like.

The ramp signal generator 160 may generate a reference signal and transmit it to the readout circuit 150.

The ramp signal generator 160 may include a current source, a resistor, and a capacitor. The ramp signal generator 160 may generate a plurality of ramp signals descending or ascending with a slope determined according to the current level of the variable current source or the resistance value of the variable resistor, by adjusting the ramp voltage, which is the voltage applied to the ramp resistor, through adjustment of the current level of the variable current source or the resistance value of the variable resistor.

The data buffer 170 may store pixel values of a plurality of pixels PX connected to a selected column line LL transmitted from the readout circuit 150, and may output the stored pixel values in response to an enable signal from the controller 110.

The image signal processor 180 may perform image signal processing on the image signal received from the data buffer 170. For example, the image signal processor 180 may receive a plurality of image signals from the data buffer 170, and may generate a single image by synthesizing the received image signals.

In some example embodiments, a plurality of pixels may be grouped in an M*N (where M and N are integers of 2 or more) form, array, or structure to constitute a single unit pixel group. The M*N type may be a type in which M are arranged in the array direction of the column line **LL** and N are arranged in the array direction of the row line RL. For example, one unit pixel group may include a plurality of pixels arranged in a 2*2 form, and one unit pixel group may output one analog pixel signal. The following example is not limited to one pixel, and may also be applied to a unit pixel group.

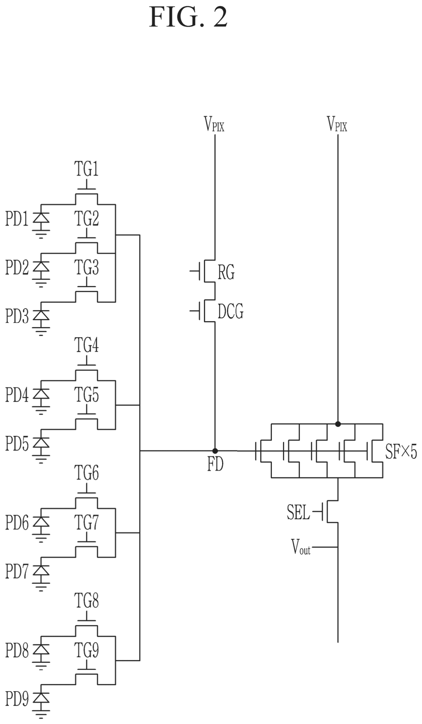

FIG. 2 is a circuit diagram of a pixel included in the image sensor according to some example embodiments of the present inventive concepts.

Referring to FIG. 2, one pixel may include a plurality of photoelectric conversion elements PD1, PD2, PD3, PD4, PD5, PD6, PD7, PD8, PD9. Each photoelectric conversion element PD1, PD2, PD3, PD4, PD5, PD6, PD7, PD8, PD9 may perform photoelectric conversion. As illustrated in FIG. 2, a plurality of photoelectric conversion elements PD1, PD2, PD3, PD4, PD5, PD6, PD7, PD8, PD9 may be connected to a single floating diffusion region FD. In FIG. 2, a configuration in which nine photoelectric conversion elements are connected to a single floating diffusion region FD has been described in some example embodiments, but this is merely illustrative, and the number of photoelectric conversion elements connected to a single floating diffusion region FD may vary depending on some example embodiments. For example, a number of floating diffusion regions FD (e.g., floating diffusion region connection patterns) included in a single pixel region may be less than a number of photoelectric conversion regions included in the single pixel region.

Hereinafter, the description will be made with reference to the first photoelectric conversion element PD1, however, the following description is equally applicable to other photoelectric conversion elements PD2, PD3, PD4, PD5, PD6, PD7, PD8, PD9.

The first photoelectric conversion element PD1 may generate and accumulate charges according to the amount of received light. The first photoelectric conversion element PD1 may include an anode connected to ground and a cathode connected to one end of the first transfer transistor TG1. A first transmission signal may be supplied to a gate of a first transfer transistor TG1, and one end of the first transfer transistor TG1 may be connected to a floating diffusion region FD. When the first transfer transistor TG1 is turned on by the first transmission signal, the charge accumulated in the first photoelectric conversion element PD1 may be transferred to the floating diffusion region FD. The floating diffusion region FD may retain charge delivered from the photoelectric conversion element PD.

Each of the plurality of transfer transistors TG1, TG2, TG3, TG4, TG5, TG6, TG7, TG8, TG9 may be connected between one of the plurality of photoelectric conversion elements PD1, PD2, PD3, PD4, PD5, PD6, PD7, PD8, PD9 and a floating diffusion region FD, and may include a gate electrode receiving a plurality of transmission signals. The number of the plurality of transfer transistors TG1, TG2, TG3, TG4, TG5, TG6, TG7, TG8, TG9 may be the same as the number of the plurality of photoelectric conversion elements PD1, PD2, PD3, PD4, PD5, PD6, PD7, PD8, PD9.

The reset transistor RG may be connected between the power supply voltage Vpix and the floating diffusion region FD and may include a gate electrode for receiving a reset signal.

The reset transistor RG may periodically reset charges accumulated in the floating diffusion region FD. The drain electrode of the reset transistor RG is connected to the source electrode of the dual conversion transistor DCG, and the source electrode may be connected to the power supply voltage Vpix. When the reset transistor RG is turned on, a power supply voltage Vpix connected to the source electrode of the reset transistor RG may be applied to the floating diffusion region FD. Therefore, when the reset transistor RG is turned on, charges accumulated in the floating diffusion region FD may be discharged, so that the floating diffusion region FD may be reset.

The dual conversion transistor DCG may be positioned between the reset transistor RG and the floating diffusion region FD, and may include a gate electrode for receiving a dual conversion signal. The dual conversion transistor DCG may reset the floating diffusion region FD together with the reset transistor RG.

The drain electrode of the dual conversion transistor DCG is connected to the floating diffusion region FD, and the source electrode of the dual conversion transistor DCG may be connected to the drain electrode of the reset transistor RG. When the reset transistor RG and the dual conversion transistor DCG are turned on, the power supply voltage Vpix connected to the source electrode of the reset transistor RG may be applied to the floating diffusion region FD through the dual conversion transistor DCG. Therefore, charges accumulated in the floating diffusion region FD may be discharged, and the floating diffusion region FD may be reset.

The source follower transistor SF may output a pixel signal according to the voltage of the floating diffusion region FD. The gate of the source follower transistor SF is connected to the floating diffusion region FD, the source electrode of the source follower transistor SF may be connected to one end of the selection transistor SEL, and a power supply voltage Vpix may be supplied to the drain electrode of the source follower transistor SF. The source follower transistor SF constitutes a source follower circuit, and may output a voltage having a level corresponding to the charge accumulated in the floating diffusion region FD as a pixel signal.

An image sensor according to some example embodiments may include a plurality of source follower transistors SF as shown in FIG. 2. As shown in FIG. 2, a plurality of source follower transistors SF connected in parallel may reduce noise. When a plurality of source follower transistors are connected in parallel, the noise of each source follower transistor may be statistically averaged, so that the total noise may be reduced. In FIG. 2, five source follower transistors SF are disclosed; however, this is merely an example, and the number of source follower transistors SF is not limited thereto. In some example embodiments, one source follower transistor SF of one pixel included in the image sensor according to some example embodiments may be included. Also, in some example embodiments, one pixel may include two or more source follower transistors SF.

When the selection transistor SEL is turned on by the selection signal, the pixel signal from the source follower transistor SF may be delivered to the readout circuit. A selection signal may be applied to the gate electrode of the selection transistor SEL, and the drain electrode of the selection transistor SEL may be connected to an output wiring Vout for outputting a plurality of pixel signals.

Operation of the image sensor will be described with reference to FIG. 2 as follows. First, in a state where light is blocked, a power supply voltage Vpix is applied to the drain electrode of the reset transistor RG and the drain electrode of the source follower transistor SF, and the reset transistor RG and the dual conversion transistor DCG are turned on so that the charges remaining in the floating diffusion region FD are discharged. Thereafter, the reset transistor RG is turned off, and when light from the outside is incident on the photoelectric conversion elements PD1, PD2, PD3, PD4, PD5, PD6, PD7, PD8, PD9, electron-hole pairs are generated in each of the photoelectric conversion elements PD1, PD2, PD3, PD4, PD5, PD6, PD7, PD8, PD9. A hole is accumulated by moving to the p-type impurity region of the photoelectric conversion element PD1, PD2, PD3, PD4, PD5, PD6, PD7, PD8, PD9, and an electron is accumulated by moving to the n-type impurity region. When the transfer transistors TG1, TG2, TG3, TG4, TG5, TG6, TG7, TG8, TG9 are turned ON, charges such as these electrons and holes are delivered to and accumulated in the floating diffusion region FD. The gate bias of the source follower transistor SF may change in proportion to the amount of accumulated charge, thereby causing a change in the source potential of the source follower transistor SF. For example, when the selection transistor SEL is turned on ON, a signal due to charge may be read out through the output wiring Vout.

Referring to FIG. 2, in the image sensor according to some example embodiments, one pixel may include nine photoelectric conversion elements PD1, PD2, PD3, PD4, PD5, PD6, PD7, PD8, PD9. For example, the floating diffusion regions FD of the 9 photoelectric conversion elements PD1, PD2, PD3, PD4, PD5, PD6, PD7, PD8, PD9 may be connected as one. Although it will be separately described below, in the image sensor according to some example embodiments, each photoelectric conversion element PD1, PD2, PD3, PD4, PD5, PD6, PD7, PD8, PD9 may be connected in several groups and may be connected to one floating diffusion region FD. In FIG. 2, a configuration in which nine photoelectric conversion elements are connected in four groups is shown. Referring to FIG. 2, the first group includes three photoelectric conversion elements PD1, PD2, PD3, the second group includes two photoelectric conversion elements PD4, PD5, the third group includes two photoelectric conversion elements PD6, PD7, and the fourth group may include two photoelectric conversion elements PD8, PD9. Hereinafter, with reference to the plan view, a detailed description will be given; however, the photoelectric conversion elements included in the same group may share one floating diffusion region connection pattern.

That is, the 9 photoelectric conversion elements may be classified into 4 groups of 3, 2, 2, and 2, respectively, and may be connected to each respective floating diffusion region connection pattern, and by connecting these 4 floating diffusion region connection patterns, the 9 floating diffusion regions may be connected as one.

Hereinafter, although a detailed plan view will be described as a reference, the image sensor according to some example embodiments may more effectively connect the nine photoelectric conversion elements by forming an open portion in the separation pattern positioned between the nine photoelectric conversion elements. Through the open portion of the separation pattern, as shown in FIG. 2, nine photoelectric conversion elements may be connected in four groups, and by connecting the four groups together, the nine photoelectric conversion elements may be more effectively connected. This may be more effective than respectively connecting nine photoelectric conversion elements and may reduce the length of the connection wiring. Therefore, parasitic capacitance due to connection wiring may be reduced. Specific connection methods and arrangements will be described later.

In FIG. 2, a configuration in which nine photoelectric conversion elements are connected as three, two, two, and two, respectively, is shown; however, this is merely an example, and the number of photoelectric conversion elements included in each of the four groups may vary.

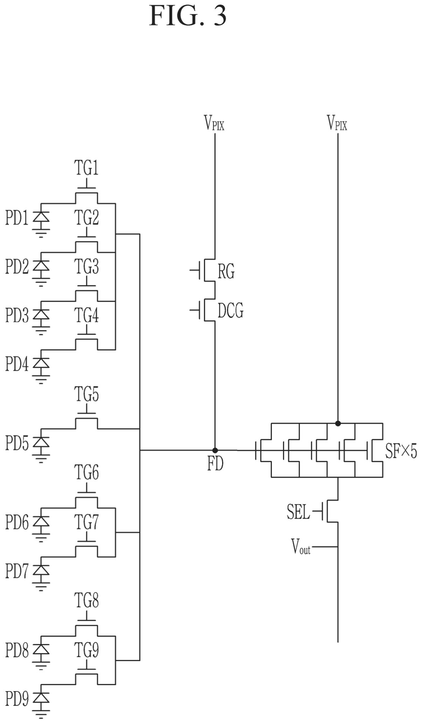

FIG. 3 illustrates the same or similar circuit diagram as FIG. 2 with respect to some example embodiments. Referring to FIG. 3, the image sensor according to some example embodiments is the same or similar as some example embodiments of FIG. 2 except that 9 photoelectric conversion elements are grouped into 4 groups, each including 4/1/2/2 photoelectric conversion elements, respectively. A detailed description of the same component will be omitted. Referring to FIG. 3, in the image sensor according to some example embodiments, a first group includes four photoelectric conversion elements PD1, PD2, PD3, PD4, a second group includes one photoelectric conversion element PD5, a third group includes two photoelectric conversion elements PD6, PD7, and a fourth group may include two photoelectric conversion elements PD8, PD9.

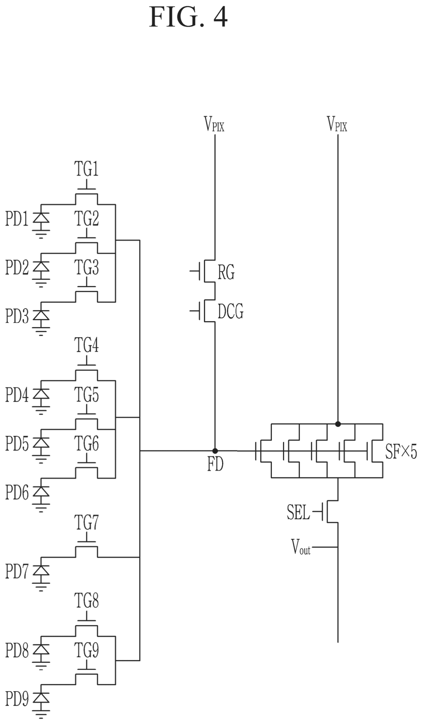

FIG. 4 shows the same or similar circuit diagram as FIG. 2 for some example embodiments. Referring to FIG. 4, the image sensor according to some example embodiments is the same or similar as some example embodiments of FIG. 2 except that nine photoelectric conversion elements are grouped into four groups, each group including three, three, one, and two photoelectric conversion elements, respectively. A detailed description of the same component is omitted. Referring to FIG. 4, in the image sensor according to some example embodiments, a first group includes three photoelectric conversion elements PD1, PD2, PD3, a second group includes three photoelectric conversion elements PD4, PD5, PD6, a third group includes one photoelectric conversion element PD7, and a fourth group may include two photoelectric conversion elements PD8, PD9.

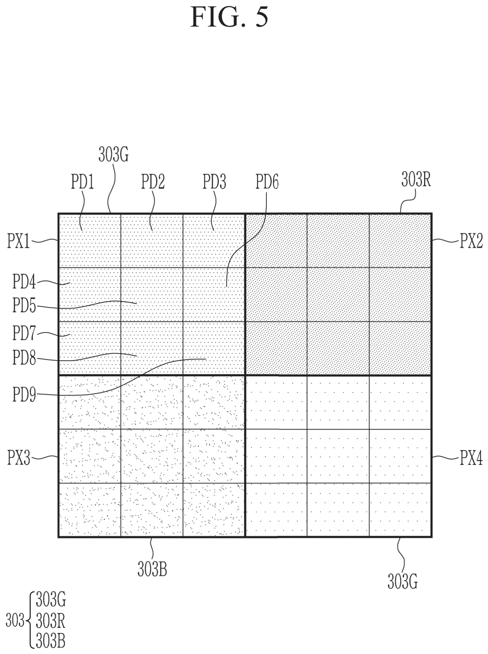

FIG. 5 schematically illustrates the planar arrangement of a plurality of pixels PX1, PX2, PX3, PX4 included in the image sensor.

With reference to FIG. 5, each pixel PX1, PX2, PX3, PX4 may include a plurality of photoelectric conversion elements PD1, PD2, PD3, PD4, PD5, PD6, PD7, PD8, PD9. In FIG. 5, each pixel is shown as including nine photoelectric conversion elements. Although not shown in FIG. 5, as illustrated in FIGS. 2 to 4, the floating diffusion region of the photoelectric conversion element included in each pixel may be connected as one.

The unit color filter 303 may be positioned on the first pixel PX1, the second pixel PX2, the third pixel PX3, and the fourth pixel PX4.

The unit color filter 303 may include primary color filters. The unit color filter 303 may include a first color filter 303G, a second color filter 303R, and a third color filter 303B, the first, second, and third color filters having different colors. In some example embodiments, the first color filter 303G, the second color filter 303R, and the third color filter 303B may each include a color filter of green, red, and blue, respectively. The first color filter, the second color filter, and the third color filter may be arranged in a Bayer pattern manner. In some example embodiments, the first color filter, the second color filter, and the third color filter may include colors such as cyan, magenta, or yellow.

In the present specification, the unit color filter 303 includes a single color filter disposed on a plurality of photoelectric conversion elements absorbing the same or similar color, or a color filter disposed on each photoelectric conversion element. That is, in FIG. 5, a respective color filter may be positioned on each of the photoelectric conversion elements PD1, PD2, PD3, PD4, PD5, PD6, PD7, PD8, PD9, or a single color filter may be positioned on the entire pixel including a plurality of photoelectric conversion elements PD1, PD2, PD3, PD4, PD5, PD6, PD7, PD8, PD9.

With reference to FIG. 5, a unit color filter of a different color may be positioned in each of the first pixel PX1, the second pixel PX2, and the third pixel PX3. In some example embodiments, a unit color filter of the same or similar color may be positioned on the first pixel PX1 and the fourth pixel PX4, but this is only some example embodiments and the present inventive concepts are not limited thereto.

Although not shown in FIG. 5, a microlens may be positioned on each pixel. The microlens may be positioned one for each photoelectric conversion element PD1, PD2, PD3, PD4, PD5, PD6, PD7, PD8, PD9, or may be commonly positioned on a plurality of photoelectric conversion elements. One microlens may be positioned on each photoelectric conversion element, or one microlens may be positioned on two photoelectric conversion elements. Alternatively, a single microlens may be positioned over all nine photoelectric conversion elements. The arrangement of the microlens may be various.

FIG. 5 schematically shows a photoelectric conversion element for convenience of explanation. Although not shown in FIG. 5, a separation pattern is positioned between each photoelectric conversion element and between pixels, and the separation pattern may include an open portion between each photoelectric conversion element to connect a plurality of photoelectric conversion elements to each other.

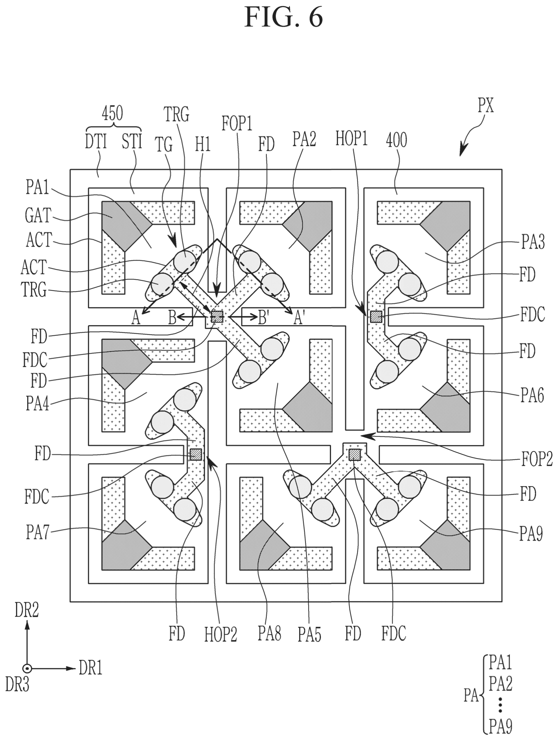

Hereinafter, a detailed structure will be described with reference to FIG. 6. FIG. 6 illustrates the planar arrangement of one pixel PX shown in FIG. 5. Referring to FIG. 6, one pixel PX according to some example embodiments may include nine photoelectric conversion regions PA1, PA2, PA3, PA4, PA5, PA6, PA7, PA8, PA9. In the present specification, the photoelectric conversion region PA1, PA2, PA3, PA4, PA5, PA6, PA7, PA8, PA9 refers to a region in which the above-described photoelectric conversion element PD1, PD2, PD3, PD4, PD5, PD6, PD7, PD8, PD9 and a transistor connected thereto are positioned. That is, in FIG. 6, the separation pattern 450, for example, each region classified by the deep trench isolation layer DTI, corresponds to the photoelectric conversion region PA.

One pixel PX may be partitioned through a separation pattern 450. The separation pattern 450 may include a deep trench isolation layer DTI and a shallow trench isolation layer STI. Each pixel PX may be separated from neighboring pixels through a deep trench isolation layer DTI.

The substrate 400 may include a plurality of photoelectric conversion regions PA1, PA2, PA3, PA4, PA5, PA6, PA7, PA8, PA9, and each of the photoelectric conversion regions PA1, PA2, PA3, PA4, PA5, PA6, PA7, PA8, PA9 may also be partitioned by a separation pattern 450, for example by a deep trench isolation layer DTI included in the separation pattern 450. As shown in FIG. 6, the deep trench isolation layer DTI may be a lattice shape extending in the first direction DR1 and the second direction DR2.

With reference to FIG. 6, within a single pixel PX, the deep trench isolation layer DTI may include four open portions FOP1, FOP2, HOP1, HOP2. The open portion FOP1, FOP2, HOP1, HOP2 may be positioned at a point where the deep trench isolation layer DTI extending in the first direction DR1 and the deep trench isolation layer DTI extending in the second direction DR2 intersect.

The open portion FOP1, FOP2, HOP1, HOP2 may include the full open portion FOP1, FOP2 and the half open portion HOP1, HOP2. In the full open portion FOP1, FOP2, the deep trench isolation layer DTI is separated in the first direction DR1 and the second direction DR2, and in the half open portion HOP1, HOP2, the deep trench isolation layer DTI may be separated in only one direction of the first direction DR1 and the second direction DR2. When referring to FIG. 6, in the full open portion FOP1, FOP2, the deep trench isolation layer DTI is spaced apart in both the first direction DR1 and the second direction DR2. Therefore, four corner portions may be opened with respect to the center of the full open portion FOP1, FOP2. In addition, referring to FIG. 6, in the half open portions HOP1, HOP2, the deep trench isolation layer DTI is separated in the first direction DR1. Therefore, in the peripheral region of the half open portion HOP1, HOP2, the deep trench isolation layer DTI adjacent in the first direction DR1 is separated by the half open portion HOP1, HOP2, but the deep trench isolation layer DTI extending in the second direction DR2 may not be separated and may be connected. Referring to FIG. 6, two sides may be open based on the center of the half open portion HOP1, HOP2.

The image sensor according to some example embodiments, as illustrated in FIG. 6, includes nine photoelectric conversion regions PA1, PA2, PA3, PA4, PA5, PA6, PA7, PA8, PA9 in one pixel PX, and the deep trench isolation layer DTI positioned in one pixel PX may include two full open portions FOP1, FOP2 and two half open portions HOP1, HOP2. In these two full open portions FOP1, FOP2 and two half open portions HOP1, HOP2, the floating diffusion regions of a plurality of photoelectric conversion elements PD1, PD2, PD3, PD4, PD5, PD6, PD7, PD8, PD9 may be connected by group. The specific connection configuration will be described separately below.

The first full open portion FOP1 and the second full open portion FOP2 may not be positioned parallel to each other in the first direction DR1 and the second direction DR2. That is, the first full open portion FOP1 and the second full open portion FOP2 may not be positioned simultaneously on an imaginary straight line parallel to the first direction DR1, and the first full open portion FOP1 and the second full open portion FOP2 may not be positioned simultaneously on an imaginary straight line parallel to the second direction DR2. In addition, the first half open portion HOP1 and the second half open portion HOP2 may not be positioned in parallel in the first direction DR1 and the second direction DR2. With reference to FIG. 6, the first full open portion FOP1 and the second full open portion FOP2 are positioned to face each other in a diagonal direction, and the first half open portion HOP1 and the second half open portion HOP2 may also be positioned to face each other in a diagonal direction. In the present specification, a diagonal direction refers to a direction positioned between the first direction DR1 and the second direction DR2.

That is, the first full open portion FOP1 may be positioned parallel to the first half open portion HOP1 in the first direction DR1, and the second full open portion FOP2 may be positioned parallel to the second half open portion HOP2 in the first direction DR1. The first full open portion FOP1 and the second half open portion HOP2 may not be positioned on the same line in the second direction DR2, and the second full open portion FOP2 and the first half open portion HOP1 may not be positioned on the same line in the second direction DR2.

As shown in FIG. 6, a substrate 400 of nine photoelectric conversion regions may be connected as one through two full open portions FOP1, FOP2 and two half open portions HOP1, HOP2. In addition, within a single pixel PX, the deep trench isolation layer DTI may be connected as one. That is, as shown in FIG. 6, although two full open portions FOP1, FOP2 and two half open portions HOP1, HOP2 are positioned therebetween, within one pixel PX, the deep trench isolation layer DTI is not disconnected but is connected as one. Therefore, when a voltage is applied to the deep trench isolation layer DTI, the voltage may be delivered without interruption. The voltage applied to the deep trench isolation layer DTI may be a negative bias. By applying such a negative bias, crosstalk of the image sensor may be suppressed and dark current may be reduced.

Although not illustrated, in the image sensor according to some example embodiments, the deep trench isolation layer DTI of all pixels may be connected as one without being interrupted. Therefore, when a voltage is applied to the deep trench isolation layer DTI in one region of the image sensor, the voltage may be delivered to the deep trench isolation layer DTI across the entire area of the image sensor without interruption.

With reference to FIG. 6, a plurality of active patterns ACT defined by a shallow trench isolation layer STI may be positioned in each photoelectric conversion region PA. An area of the substrate 400 in which a shallow trench isolation layer STI is not formed may be referred to as an active pattern ACT. In addition, the gate electrode GAT may be positioned to overlap the active pattern ACT. The gate electrode GAT and the active pattern ACT may constitute one transistor among the transistors described in FIGS. 2 to 4. That is, the gate electrode GAT overlapping the active pattern ACT may constitute one of the reset transistor RG, the dual conversion transistor DCG, the source follower transistor SF, and the selection transistor SEL.

Also, referring to FIG. 6, the transfer gate electrode TRG may be positioned to overlap the active pattern ACT. The transfer gate electrode TRG overlapping the active pattern ACT may constitute the transfer transistor TG described above in FIGS. 2 to 4. As shown in FIG. 6, two gate electrodes TRG may be positioned to overlap with the active pattern ACT. These two gate electrodes TRG may more effectively transfer charges generated in the photoelectric conversion region to the floating diffusion region FD. However, this is some example embodiments, and the transfer transistor TG may include a single gate electrode TRG. A portion of the active pattern ACT included in the transfer transistor TG may constitute the floating diffusion region FD.

With reference to FIG. 6, the floating diffusion region FD positioned in each photoelectric conversion region PA may be connected to each other at the full open portion FOP1, FOP2 or the half open portion HOP1, HOP2 of the deep trench isolation layer DTI.

Referring to FIG. 6, in the first full open portion FOP1 of the deep trench isolation layer DTI, the floating diffusion region FD positioned in the first photoelectric conversion region PA1, the second photoelectric conversion region PA2, and the fifth photoelectric conversion region PA5 may be connected as one. The floating diffusion region connection pattern FDC may be positioned overlapping with the floating diffusion region FD positioned in the first full open portion FOP1. Although it will be separately described below, the image sensor according to some example embodiments may be connected through the floating diffusion region connection pattern FDC positioned in the full open portion FOP1, FOP2 and the half open portion HOP1, HOP2 of the deep trench isolation layer DTI, instead of individually connecting the floating diffusion region FD positioned in each photoelectric conversion region. The full open portions FOP1, FOP2 and half open portions HOP1, HOP2 of the deep trench isolation layer DTI are connected to the floating diffusion regions FD of a plurality of photoelectric conversion regions PA, and therefore, the floating diffusion regions FD positioned in each of the photoelectric conversion regions PA may be more effectively connected as one. This may connect the floating diffusion region FD more effectively than individually connecting the floating diffusion region FD positioned in each photoelectric conversion region PA.

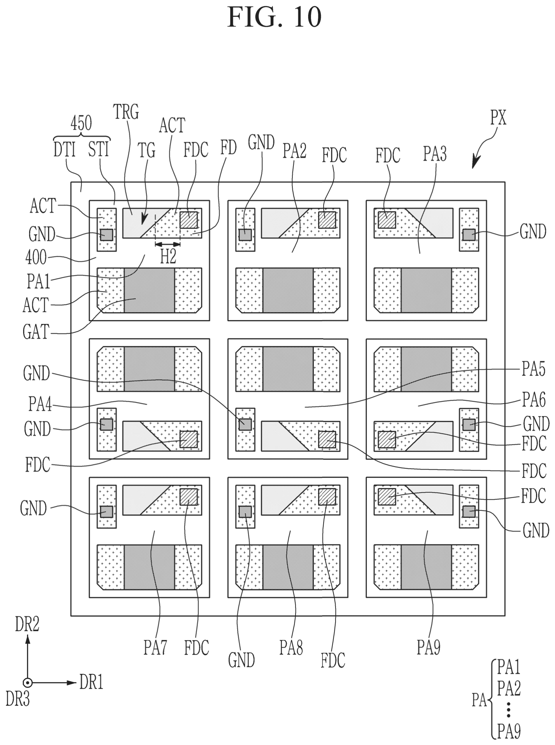

With reference to FIG. 6, the gate electrode TRG may be positioned in a diagonal direction with respect to the floating diffusion region connection pattern FDC. As the transfer gate electrode TRG is positioned in a diagonal direction of the floating diffusion region connection pattern FDC, the distance between the transfer gate electrode TRG and the floating diffusion region connection pattern FDC may be increased within the limited space. Therefore, it may be possible to reduce the influence of a voltage change of the gate electrode TRG on the floating diffusion region connection pattern FDC. The specific effects will be described later. In FIG. 6, a first distance H1 between the transfer gate electrode TRG and the floating diffusion region connection pattern FDC is shown. This will be described in detail later; however, the first distance H1 may be longer than the second distance H2 between the transfer gate electrode TRG and the floating diffusion region connection pattern FDC in some example embodiments of FIG. 10. In addition, as two transfer gate electrodes TRG are included, transfer performance may be improved, and the transfer transistor may be driven at a low voltage.

However, the arrangement of the active pattern ACT, gate electrode GAT, and transfer gate electrode TRG shown in FIG. 6 is merely an example, and the present inventive concepts are not limited thereto. The arrangement of the active pattern ACT, the gate electrode GAT, and the transfer gate electrode TRG may vary according to some example embodiments.

With reference to FIG. 6, in the first half open portion HOP1 of the deep trench isolation layer DTI, the floating diffusion region FD positioned in the third photoelectric conversion region PA3 and the sixth photoelectric conversion region PA6 may be connected as one. Also, in the second half open portion HOP2, the floating diffusion region FD positioned in the fourth photoelectric conversion region PA4 and the seventh photoelectric conversion region PA7 may be connected as one. In addition, in the second full open portion FOP2, the floating diffusion region FD positioned in the eighth photoelectric conversion region PA8 and the ninth photoelectric conversion region PA9 may be connected as one.

Each of the first full open portion FOP1, the second full open portion FOP2, the first half open portion HOP1, and the second half open portion HOP2 is positioned with a floating diffusion region connection pattern FDC, and the floating diffusion region FD of each photoelectric conversion region PA may be connected as one through the floating diffusion region connection pattern FDC.

Referring to FIG. 6, the separation pattern 450 according to some example embodiments, for example, the deep trench isolation layer DTI, may include an outer separation pattern and an inner separation pattern. The outer separation pattern may surround an edge of a pixel including nine photoelectric conversion regions arranged in three columns and three rows in plan view. That is, the outer separation pattern may be positioned along the edges of the nine photoelectric conversion regions. As shown in FIG. 6, the outer separation pattern may include a first outer separation pattern positioned in a first direction DR1 in plan view and a second outer separation pattern positioned in a second direction DR2 intersecting the first direction DR1. As shown in FIG. 6, the outer separation pattern may be integrally connected without an open portion. That is, the first outer separation pattern and the second outer separation pattern do not include an open portion, and the first outer separation pattern and the second outer separation pattern may also be connected as one without any disconnected portion.

Also, the separation pattern may include an inner separation pattern positioned between photoelectric conversion regions included within one pixel region. The inner separation pattern may include a first inner separation pattern positioned in a first direction DR1 in plan view and a second inner separation pattern positioned in a second direction DR2 intersecting the first direction DR1 in plan view. The first inner separation pattern may include a plurality of first inner sub separation patterns spaced apart from each other with the open portion therebetween, and the second inner separation pattern may include a plurality of second inner sub separation patterns spaced apart from each other with the open portion therebetween. With reference to FIG. 6, in the first direction DR1, two open portions are positioned, and the first inner separation pattern may include three first inner sub separation patterns. In the second direction DR2, one open portion is positioned, and the second inner separation pattern may include two second inner sub separation patterns. That is, the number of first inner sub separation patterns may be greater than the number of second inner sub separation patterns. With reference to FIG. 6, two first inner separation patterns are positioned in one pixel region, and a total of six first inner sub separation patterns may be positioned in one pixel region. Also, referring to FIG. 6, in one pixel region, two second inner separation patterns are positioned, and a total of four second inner sub separation patterns may be positioned within one pixel region.

In the image sensor according to some example embodiments, the floating diffusion region may include two portions. For example, a floating diffusion region formed by doping inside a substrate 400 including silicon, and a floating diffusion region including a contact and metal wiring and/or a polysilicon pad for electrically connecting between a plurality of floating diffusion regions that are not connected within the substrate 400 and/or between the floating diffusion region and a source follower gate, may be included. The floating diffusion region formed in the silicon substrate through doping may be referred to as a junction floating diffusion region, a silicon floating diffusion region, and the like, and the floating diffusion region consisting of a contact, metal wiring, and/or a polysilicon pad may be separately referred to as a wiring floating diffusion region. Unless otherwise specified in the present specification, a description regarding the position of the floating diffusion region may be regarded as a description for the junction floating diffusion region. The expression that the floating diffusion region formed in the first photoelectric conversion region and the floating diffusion region formed in the second photoelectric conversion region are connected may mean that the first photoelectric conversion region and the second photoelectric conversion region share one junction floating diffusion region.

That is, the pixel of some example embodiments may include first to third photoelectric conversion regions sharing a first junction floating diffusion region, fourth and fifth photoelectric conversion regions sharing a second junction floating diffusion region, sixth and seventh photoelectric conversion regions sharing a third junction floating diffusion region, and eighth and ninth photoelectric conversion regions sharing a fourth junction floating diffusion region. The arrangement of the photoelectric conversion regions of Claims 1 to 9 is not limited to what is illustrated in FIG. 6.

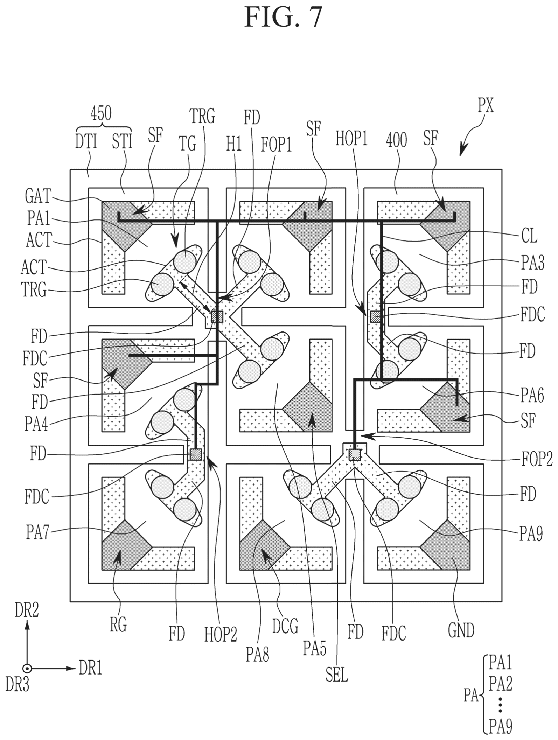

FIG. 7 schematically shows the connection relationship of the floating diffusion region FD in the image sensor according to some example embodiments of FIG. 6. Referring to FIG. 7, a floating diffusion region connection pattern FDC positioned in the first full open portion FOP1, the second full open portion FOP2, the first half open portion HOP1, and the second half open portion HOP2 may be connected as one through connection wiring CL.

In addition, FIG. 7 illustrates a transistor formed by each gate electrode GAT and the active pattern ACT overlapping therewith. Referring to FIG. 7, the floating diffusion region FD connected as one through the connection wiring CL may be connected to five source follower transistors SF connected in parallel.

Of the nine gate electrodes GAT illustrated in FIG. 7, five gate electrodes configure the source follower transistor SF, and of the remaining four, three may respectively configure the reset transistor RG, the dual conversion transistor DCG, and the selection transistor SEL. The other one may be a ground voltage application pattern GND for applying a ground voltage to the substrate 400. However, such an arrangement of the gate electrode GAT is merely an example and is not limited thereto. That is, the arrangement of the transistors illustrated in FIG. 7 is merely an example, and the transistors formed by each gate electrode GAT may differ from those shown in FIG. 7.

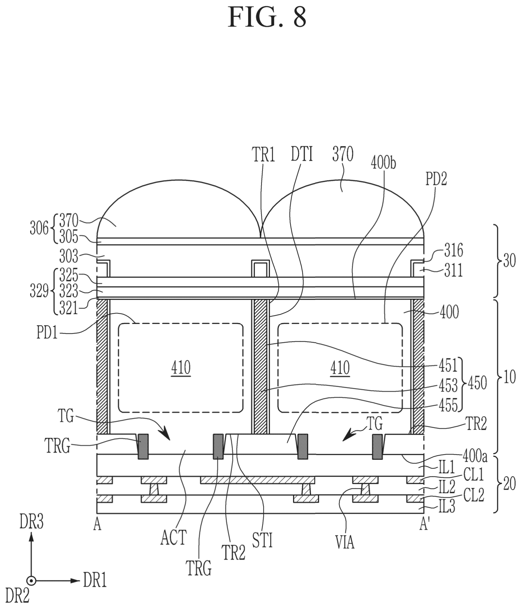

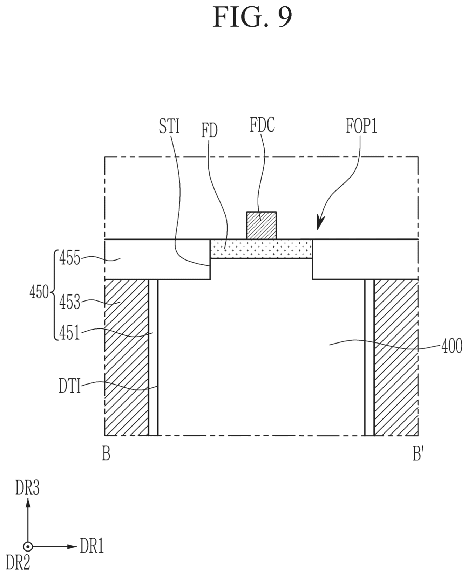

Hereinafter, the stacked structure of the image sensor according to some example embodiments will be described with reference to a cross-sectional view. FIG. 8 is a cross-sectional view showing the image sensor of FIG. 6 cut along line A-A', and FIG. 9 is a cross-sectional view showing the image sensor of FIG. 6 cut along line B-B'. FIG. 9 illustrates only a portion of the cross-sectional view in the third direction DR3 for convenience of explanation.

Referring simultaneously to FIGS. 6 to 9, the image sensor according to some example embodiments includes a first substrate 400. The first substrate 400 may include a first surface 400a and a second surface 400b facing each other. Light may be incident on the second surface 400b of the first substrate 400. The first wiring region 20 may be positioned on the first surface 400a of the first substrate 400, and the light transmitting layer 30 may be positioned on the second surface 400b of the first substrate 400. The first substrate 400 may be a semiconductor substrate or an SOI (silicon on insulator) substrate. By way of example, the semiconductor substrate may include a silicon substrate, a germanium substrate, or a silicon-germanium substrate. The first substrate 400 may include an impurity of a first conductivity type. In some example embodiments, an impurity of a first conductivity type may be a p-type impurity such as aluminum (Al), boron (B), indium (In), and/or gallium (Ga).

The first substrate 400 may include a separation pattern 450. The separation pattern 450 may partition a plurality of unit pixels and a plurality of photoelectric conversion regions within one pixel. FIG. 8 illustrates a portion of the cross-sectional view of one pixel, and two photoelectric conversion regions in cross-sectional view are shown. However, this is a virtual cross-sectional view for convenience of explanation, and the present inventive concepts are not limited thereto. That is, as illustrated in FIG. 6, one pixel may include nine photoelectric conversion regions.

The first substrate 400 may include a photoelectric conversion doped region 410. The photoelectric conversion doped region 410 may perform the same function and role as the photoelectric conversion elements PD1, PD2, PD3, PD4, PD5, PD6, PD7, PD8, PD9 shown in FIGS. 2 to 5. FIG. 7 shows a first photoelectric conversion element PD1 and a second photoelectric conversion element PD2.

The photoelectric conversion doped region 410 may be a region doped with an impurity of a second conductivity type in the first substrate 400. The impurity of a second conductivity type may have a conductivity type opposite to the impurity of a first conductivity type. The impurity of a second conductivity type may be an n-type impurity such as phosphorus, arsenic, bismuth, and/or antimony. In some example embodiments, each photoelectric conversion doped region 410 may include a first region adjacent to the first surface 400a and a second region adjacent to the second surface 400b. A difference in impurity concentration may be present between the first region and the second region of the photoelectric conversion doped region 410. Therefore, the photoelectric conversion doped region 410 may have a potential gradient between the first surface 400a and the second surface 400b of the first substrate 400. However, in some example embodiments, the photoelectric conversion doped region 410 may not have a potential gradient between the first surface 400a and the second surface 400b of the first substrate 400.

The first substrate 400 and the photoelectric conversion doped region 410 may constitute a photodiode. That is, a photodiode may be configured by a p-n junction between the first substrate 400 having the first conductivity type and the photoelectric conversion doped region 410 having the second conductivity type. The photoelectric conversion doped region 410 configuring the photodiode may generate and accumulate photocharges in proportion to the intensity of incident light.

Referring to FIG. 6 and FIG. 8 simultaneously, the separation pattern 450 may be positioned on the first substrate 400. The separation pattern 450 in plan view may have a lattice structure. The separation pattern 450 may partition each pixel in plan view, and may be positioned between a plurality of photoelectric conversion elements PD1, PD2, PD3, PD4, PD5, PD6, PD7, PD8, PD9 included in a single pixel.

Referring to FIG. 8, the separation pattern 450 may be positioned in the first trench TR1 and the second trench TR2. The first trench TR1 and the second trench TR2 may penetrate through the first substrate 400 in a portion of the first surface 400a of the substrate 400 or may be recessed from the substrate 400. As shown in FIG. 8, the first trench TR1 may be formed deeper than the second trench TR2. The separation pattern 450 may extend from the first surface 400a of the first substrate 400 toward the second surface 400b. The separation pattern 450 may include a deep trench isolation layer DTI and a shallow trench isolation layer STI. The separation pattern 450 may penetrate the first substrate 400. The vertical height of the separation pattern 450 may be substantially the same as the vertical thickness of the first substrate 400. For example, the width of the separation pattern 450 may gradually decrease from the first surface 400a of the first substrate 400 toward the second surface 400b. However, this is merely an example, and the present inventive concepts are not limited thereto. In some example embodiments, the width of the separation pattern 450 may gradually increase from the first surface 400a of the first substrate 400 toward the second surface 400b. Alternatively, the width of the separation pattern 450 may be constant between the first surface 400a and the second surface 400b of the first substrate 400.

The separation pattern 450 may include a first separation pattern 451, a second separation pattern 453, and a third separation pattern 455. The first separation pattern 451 and the second separation pattern 453 constitute the deep trench isolation layer DTI, and the third separation pattern 455 may constitute the shallow trench isolation layer STI.

The first separation pattern 451 may be positioned along a sidewall of the first trench TR1. The first separation pattern 451 may include, for example, a silicon-based insulating material (for example, silicon nitride, silicon oxide, or silicon oxynitride) or a high dielectric constant material (for example, hafnium oxide or aluminum oxide). In some example embodiments, the first separation pattern 451 may include a plurality of layers, and each layer may include a different material. The first separation pattern 451 may have a lower refractive index than the first substrate 400. Accordingly, crosstalk phenomenon between respective photoelectric conversion regions positioned on the first substrate 400 may be prevented or reduced.

The second separation pattern 453 may be positioned within the first separation pattern 451. For example, a sidewall of the second separation pattern 453 may be surrounded by the first separation pattern 451. The first separation pattern 451 may be positioned between the second separation pattern 453 and the first substrate 400. The second separation pattern 453 may be spaced apart from the first substrate 400 by the first separation pattern 451. Accordingly, during operation of the image sensor, the second separation pattern 453 may be electrically separated from the first substrate 400. The second separation pattern 453 may include a crystalline semiconductor material, for example, polycrystalline silicon. In some example embodiments, the second separation pattern 453 may further include a dopant, and the dopant may include an impurity of a first conductivity type or an impurity of a second conductivity type.

For example, the second separation pattern 453 may include doped polycrystalline silicon. Alternatively, the second separation pattern 453 may include an undoped crystalline semiconductor material. For example, the second separation pattern 453 may include undoped polycrystalline silicon. The term "undoped" may mean that an intentional doping process is not performed. The dopant may include an n-type dopant and a p-type dopant. However, the second separation pattern 453 may include an insulating material.

The third separation pattern 455 may be positioned on a lower surface of the second separation pattern 453. The third separation pattern 455 may be positioned in the second trench TR2 and may be disposed adjacent to the first surface 400a of the first substrate 400. The third separation pattern 455 may include a non-conductive material. In some example embodiments, the third separation pattern 455 may include a silicon-based insulating material (for example, silicon nitride, silicon oxide, or silicon oxynitride) or a high dielectric constant material (for example, hafnium oxide or aluminum oxide). Accordingly, the separation pattern 450 may prevent or reduce photocharges generated by incident light entering the photoelectric conversion region from being introduced into an adjacent photoelectric conversion region due to random drift. That is, the separation pattern 450 may prevent or reduce the crosstalk phenomenon between the photoelectric conversion regions.

According to some example embodiments, the first separation pattern 451 and the third separation pattern 455 may include the same or similar material, and for example, a boundary between the first separation pattern 451 and the third separation pattern 455 may not be visually distinguishable and may appear to be connected as one.

In FIG. 8, a configuration is illustrated in which the separation pattern 450 and the first surface 400a of the first substrate 400 are positioned on the same plane in plan view; however, this is merely an example, and some example embodiments is not limited thereto. By way of example, the separation pattern 450 and the first surface 400a of the first substrate 400 may not form a coplanar surface. The separation pattern 450 may be positioned to protrude from or be depressed in the first surface 400a of the first substrate 400.

Also, in FIG. 8, the upper surface of the separation pattern 450 is illustrated as flat, but this is merely an example, and the upper surface of the separation pattern 450 may include a curved surface. That is, the upper surface of the separation pattern 450 may have a structure depressed toward or protruded toward the first surface 400a of the substrate 400.

The transfer transistor TG described in FIG. 2 may be positioned on the first surface 400a of the first substrate 400. The transfer transistor TG may be electrically connected to the photoelectric conversion doped region 410. With reference to FIG. 6 and FIG. 8 simultaneously, the transfer transistor TG may include a transfer gate electrode TRG and a floating diffusion region FD positioned on the active pattern ACT. In FIGS. 6 to 8, a configuration having two gate electrodes TRG is illustrated, but this is merely an example, and the gate electrode TRG may be one.

The floating diffusion region FD may be adjacent to one side of the gate electrode TRG. The floating diffusion region FD may be positioned in the active pattern ACT. The floating diffusion region FD may have a second conductivity type (for example, n-type) opposite to the first substrate 400.

The wiring region 20 may be positioned on the first surface 400a of the first substrate 400, and may include a plurality of insulating layers IL1, IL2, IL3, a plurality of wiring layers CL1, CL2, and a plurality of vias VIA.

The insulating layer may include a first insulating layer IL1, a second insulating layer IL2, and a third insulating layer IL3.

The first insulating layer IL1 may cover the first surface 400a of the first substrate 400. The first insulating layer IL1 may cover the gate electrode TRG. The second insulating layer IL2 may be positioned on the first insulating layer IL1. The third insulating layer IL3 may be positioned on the second insulating layer IL2.

The first to third insulating layers IL1, IL2, IL3 may include a non-conductive material. For example, the first to third insulating layers IL1, IL2, IL3 may include a silicon-based insulating material such as silicon oxide, silicon nitride, or silicon oxynitride.

The wiring layer CL1, CL2 may include a first wiring layer CL1 and a second wiring layer CL2. The first wiring layer CL1 may be positioned in the second insulating layer IL2. The second wiring layer CL2 may be positioned in the third insulating layer IL3.

The wiring positioned on each of the first wiring layer CL1 and the second wiring layer CL2 may be connected to the floating diffusion region FD through a via VIA. The via VIA may penetrate the insulating layer IL1, IL2, IL3.

Also, the image sensor according to some example embodiments may include a light transmitting layer 30. The light transmitting layer 30 may include an insulating structure 329, a unit color filter 303, and a microlens portion 306. The light transmitting layer 30 may condense and filter light incident from the outside, and may provide the light to the photoelectric conversion doped region 410.

A unit color filter 303 may be positioned on the second surface 400b of the substrate 400. A color filter included in pixels arranged in an N×M array absorbing the same or similar color may be positioned as a single color filter over all N×M pixels, or a separate color filter may be positioned for each pixel respectively. In the present specification, the unit color filter 303 includes a single color filter disposed in a plurality of pixels that absorb the same or similar color or a color filter disposed in each pixel.

The insulating structure 329 may be positioned between the second surface 400b of the substrate 400 and the unit color filter 303. The insulating structure 329 may prevent or reduce reflection of light so that light incident on the second surface 400b of the substrate 400 may smoothly reach the photoelectric conversion doped region 410. The insulating structure 329 may be referred to as an antireflection structure.

The insulating structure 329 may include a first fixed charge layer 321, a second fixed charge layer 323, and a planarization layer 325 sequentially stacked on the second surface 400b of the substrate 400. The first fixed charge layer 321, the second fixed charge layer 323, and the planarization layer 325 may each include a different material. The first fixed charge layer 321 may include any one of aluminum oxide, tantalum oxide, titanium oxide, and hafnium oxide. The second fixed charge layer 323 may include any one of aluminum oxide, tantalum oxide, titanium oxide, and hafnium oxide. In some example embodiments, the first fixed charge layer 321 may include aluminum oxide, the second fixed charge layer 323 may include hafnium oxide, and the planarization layer 325 may include silicon oxide. Although not illustrated, in some example embodiments, a silicon reflective anti-reflection layer (not shown) may be interposed between the second fixed charge layer 323 and the planarization layer 325. The reflective anti-reflection layer may include silicon nitride.

A microlens portion 306 may be positioned on the unit color filter 303. The microlens portion 306 may include a flat portion 305 contacting the unit color filter 303 and a microlens 307 positioned on the flat portion 305. The flat portion 305 may, for example, include an organic material. In some example embodiments, the flat portion 305 may include silicon oxide or silicon oxynitride. The microlens 307 may have a convex shape so as to collect incident light. Each microlens 307 may be vertically overlapped with the photoelectric conversion region. The shape of the lens may be varied. For convenience of explanation, FIG. 8 illustrates one microlens 307 in a shape in which it is overlapped with one photoelectric conversion region in cross-sectional view. However, in plan view, one microlens 307 may be positioned in a shape overlapping with a plurality of photoelectric conversion regions. However, this is merely an example, and the number of microlenses 307 positioned on one pixel PX may vary.

The light transmitting layer 30 may further include a Bayer pattern 311 and a passivation layer 316. The Bayer pattern 311 may be positioned between unit color filters 303 adjacent to each other to separate them from each other. As shown in FIG. 8, the Bayer pattern 311 may be positioned between photoelectric conversion regions, or, unlike as shown in FIG. 8, may not be positioned between photoelectric conversion regions but may be positioned between pixels.

The Bayer pattern 311 may be positioned on the insulating structure 329. By way of example, the Bayer pattern 311 may have a lattice structure. The Bayer pattern 311 may include a material having a lower refractive index than the unit color filter 303. The Bayer pattern 311 may include an organic material. For example, the Bayer pattern 311 may be a polymer layer including silica nanoparticles. The Bayer pattern 311 has a low refractive index, and thus, the amount of incident light to the photoelectric conversion doped region 410 may be increased, and crosstalk between pixels PX may be reduced. That is, in each photoelectric conversion doped region 410, the light receiving efficiency may be increased, and the SNR (Signal Noise Ratio) characteristic may be improved.

The passivation layer 316 may cover the surface of the Bayer pattern 311 with a substantially uniform thickness. The passivation layer 316 may include, for example, at least one single layer or multi-layer of an aluminum oxide layer and a silicon oxycarbide layer. The passivation layer 316 may protect the unit color filter 303 and perform a moisture-absorbing function. In FIG. 8, the passivation layer 316 is shown in a separated configuration; however, in some example embodiments, the passivation layer 316 may be connected as one between adjacent Bayer patterns 311.

In addition, in accordance with some example embodiments, the configuration of the Bayer pattern 311 and the passivation layer 316 in the cross-sectional view of FIG. 8 may be omitted. The Bayer pattern 311 and the passivation layer 316 may be positioned between adjacent pixel regions, and may not be positioned between the photoelectric conversion regions of one pixel.

FIG. 9 is a cross-sectional view of the image sensor of FIG. 6 taken along line B-B', showing a cross section of the first full open portion FOP1. FIG. 9 shows a portion of the cross-sectional view for convenience of explanation. With reference to FIG. 9, a floating diffusion region FD and a floating diffusion region connection pattern FDC may be positioned in the first full open portion FOP1. With simultaneous reference to FIG. 6, FIG. 7, and FIG. 9, the floating diffusion region FD positioned in the first photoelectric conversion region PA1, the second photoelectric conversion region PA2, and the third photoelectric conversion region PA3 is connected as one in the first full open portion FOP1, and may be connected to the floating diffusion region FD of another photoelectric conversion region through the floating diffusion region connection pattern FDC.

According to some example embodiments, the image sensor includes a separation pattern 450 including full open portions FOP1, FOP2 and half open portions HOP1, HOP2, and connects the floating diffusion region FD of a plurality of photoelectric conversion regions PA as one in the full open portions FOP1, FOP2 and the half open portions HOP1, HOP2. Therefore, it is possible to more effectively connect the floating diffusion region FD of the plurality of photoelectric conversion regions PA, and the length of the connection wiring used for the connection may be reduced, whereby the parasitic capacitance caused by the connection wiring may be reduced.

FIG. 10 illustrates some example embodiments of pixel arrangement in a case where the separation pattern 450 does not include an open portion. Referring to FIG. 10, in some example embodiments, the separation pattern 450 may not include an open portion between the plurality of photoelectric conversion regions PA. Accordingly, as shown in FIG. 10, the floating diffusion region FD positioned at each photoelectric conversion region PA may not be connected in plan view with the floating diffusion region FD positioned at another photoelectric conversion region PA. With reference to the first photoelectric conversion region PA1 of FIG. 10, a plurality of active patterns ACT, gate electrodes GAT positioned to overlap each of the active patterns ACT, transfer gate electrodes TRG, and ground voltage application patterns GND may be positioned in the first photoelectric conversion region PA1 defined by the separation pattern 450, for example by the deep trench isolation layer DTI.

A transfer gate electrode TRG overlapping the active pattern ACT may constitute a transfer transistor TG. With reference to FIG. 10, a floating diffusion region connection pattern FDC is positioned on the floating diffusion region FD of the transfer transistor TG. For example, because the floating diffusion region FD of each photoelectric conversion region PA is separated, a floating diffusion region connection pattern FDC is also required for each photoelectric conversion region PA. In addition, since the separation pattern 450 does not include an open portion, the substrate 400 of each photoelectric conversion region PA is separated, and therefore, a ground voltage application pattern GND for applying ground voltage to the substrate 400 is also required for each photoelectric conversion region PA. Referring to FIG. 10, one pixel PX includes nine photoelectric conversion region PA, and therefore, nine floating diffusion region connection pattern FDC and ground voltage application pattern GND may be positioned in one pixel PX. In order to connect such a floating diffusion region connection pattern FDC as one, the wiring may become long and complicated, which may cause parasitic capacitance due to the wiring and reduce the conversion gain of the image sensor.

In addition, since both the floating diffusion region connection pattern FDC and the ground voltage application pattern GND are positioned within one photoelectric conversion region PA, design flexibility may be reduced, and the distance between the floating diffusion region connection pattern FDC and the transfer gate electrode TRG may become shorter. This may cause GIDL (Gate-Induced Drain Leakage) and CA Leakage (Contact Area Leakage). That is, when the floating diffusion region connection pattern FDC and the transfer gate electrode TRG are physically close, electric field interference caused by the transfer gate electrode TRG may affect the floating diffusion region connection pattern FDC.

The distance H2 between the floating diffusion region connection pattern FDC and the transfer gate electrode TRG as illustrated in FIG. 10 may be shorter than the distance H1 between the floating diffusion region connection pattern FDC and the transfer gate electrode TRG as illustrated in FIG. 6. In FIG. 10, one side of the transfer gate electrode TRG has an inclined shape, and the distance H2 between the floating diffusion region connection pattern FDC and the transfer gate electrode TRG is illustrated based on the center of the inclined surface of the transfer gate electrode TRG. In the case of FIG. 10, due to the limited space within the photoelectric conversion region, it is difficult to position two transfer gate electrodes TRG, and this may result in reduced transfer performance compared to some example embodiments of FIG. 6 including two transfer gate electrodes TRG.

However, as described above, the image sensor according to some example embodiments includes a separation pattern 450 including an open portion. The substrate of the photoelectric conversion region included in one pixel through the open portion is connected as one, and thus, a ground voltage may be applied to the nine photoelectric conversion regions PA with one ground voltage application pattern. In addition, in the full open portion FOP1, FOP2 and the half open portion HOP1, HOP2 of the separation pattern, the floating diffusion regions FD of a plurality of photoelectric conversion regions PA are connected as one, and the floating diffusion region connection pattern FDC may be positioned in these full open portion FOP1, FOP2 and half open portion HOP1, HOP2 to connect the floating diffusion regions FD as one. Therefore, it is possible to not individually position the floating diffusion region connection pattern FDC and the ground voltage application pattern GND within each photoelectric conversion region PA, so space may be efficiently utilized. Accordingly, the distance between the floating diffusion region connection pattern FDC and the transfer gate electrode TRG may be increased, so that the influence of the electric field variation of the transfer gate electrode TRG on the floating diffusion region connection pattern FDC may be reduced.

In addition, by connecting the floating diffusion regions FD of a plurality of photoelectric conversion regions PA as one through the floating diffusion region connection pattern FDC, the length of the connection wiring may be reduced, and the parasitic capacitance generated by the connection wiring may be minimized.

In FIG. 6, the planar arrangement of the pixel according to some example embodiments was described, but it is not limited thereto. That is, the image sensor according to some example embodiments includes one pixel including nine photoelectric conversion regions, and if the separation pattern 450 included in one pixel includes two full open portions and two half open portions such that substrates of the nine photoelectric conversion regions are connected as one, the planar arrangement is not limited to a specific shape.

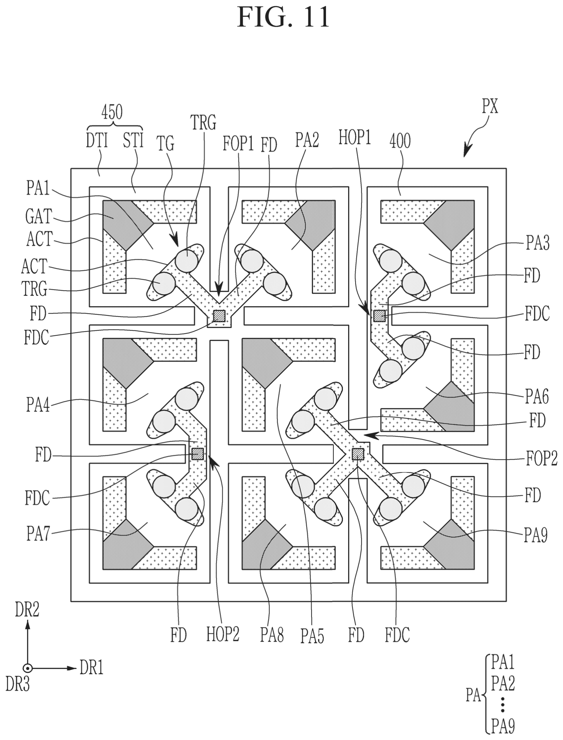

FIG. 11 illustrates the same or similar region as FIG. 6 with respect to some example embodiments. Referring to FIG. 11, the image sensor according to some example embodiments is the same or similar as some example embodiments of FIG. 6 except for the arrangement of the fifth photoelectric conversion region PA5. A detailed description for the same component will be omitted. Referring to FIG. 11, the image sensor according to some example embodiments is the same or similar as FIG. 6 except that the floating diffusion region FD of the fifth photoelectric conversion region PA5 is connected to the second full open portion FOP2 instead of the first full open portion FOP1. That is, referring to FIG. 11, in the first full open portion FOP1, the floating diffusion region FD of the first photoelectric conversion region PA1 and the floating diffusion region FD of the second photoelectric conversion region PA2 may be connected as one. In addition, in the first half open portion HOP1, the floating diffusion region FD positioned in the third photoelectric conversion region PA3 and the sixth photoelectric conversion region PA6 may be connected as one. In the second half open portion HOP2, the floating diffusion region FD positioned at the fourth photoelectric conversion region PA4 and the seventh photoelectric conversion region PA7 may be connected as one. In addition, in the second full open portion FOP2, the floating diffusion region FD positioned in the fifth photoelectric conversion region PA5, the eighth photoelectric conversion region PA8, and the ninth photoelectric conversion region PA9 may be connected as one. In some example embodiments of FIG. 11, the substrate 400 of the nine photoelectric conversion regions is connected as one, and the floating diffusion region FD of each photoelectric conversion region may be connected as one through four floating diffusion region connection patterns FDC. In addition, in one pixel PX, the deep trench isolation layer DTI is connected as one without an island-type separated portion.

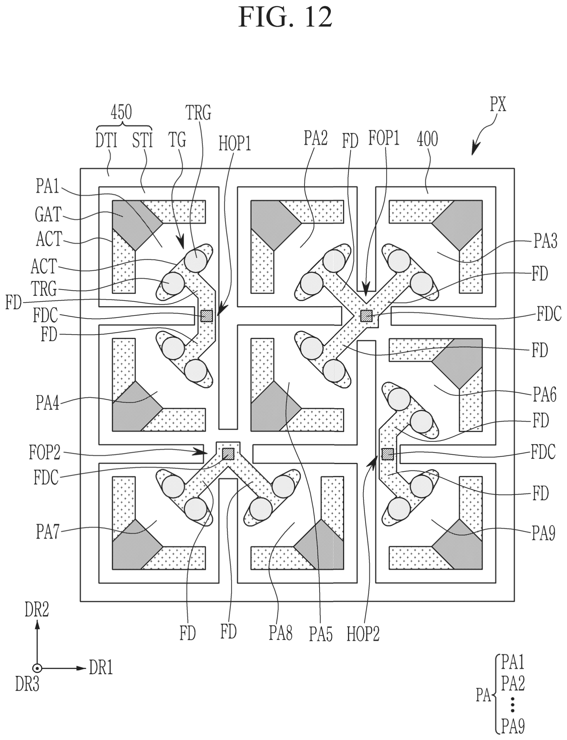

FIG. 12 illustrates the same or similar region as FIG. 6 with respect to some example embodiments. Referring to FIG. 12, the image sensor according to some example embodiments has positions of the first full open portion FOP1, first half open portion HOP1, second full open portion FOP2, and second half open portion HOP2 that are different from those in FIG. 6. That is, in the case of FIG. 6, the first full open portion FOP1 is positioned at the corner where the first photoelectric conversion region PA1, the second photoelectric conversion region PA2, the fourth photoelectric conversion region PA4, and the fifth photoelectric conversion region PA5 meet, whereas in the case of FIG. 12, the first half open portion HOP1 may be positioned at the corner where the first photoelectric conversion region PA1, the second photoelectric conversion region PA2, the fourth photoelectric conversion region PA4, and the fifth photoelectric conversion region PA5 meet. Referring to FIG. 12, in the first half open portion HOP1, the floating diffusion region FD of the first photoelectric conversion region PA1 and the fourth photoelectric conversion region PA4 may be connected as one. In addition, in the first full open portion FOP1, the floating diffusion region FD positioned in the second photoelectric conversion region PA2, the third photoelectric conversion region PA3, and the fifth photoelectric conversion region PA5 may be connected as one. In the second full open portion FOP2, the floating diffusion region FD positioned in the seventh photoelectric conversion region PA7 and the eighth photoelectric conversion region PA8 are connected as one, and in the second half open portion HOP2, the floating diffusion region FD of the sixth photoelectric conversion region PA6 and the ninth photoelectric conversion region PA9 may be connected as one. In some example embodiments of FIG. 12, the substrate 400 of the nine photoelectric conversion regions is connected as one, and the floating diffusion region FD of each photoelectric conversion region may be connected as one through four floating diffusion region connection patterns FDC. In addition, in a single pixel PX, the deep trench isolation layer DTI is connected as one without an island-type separated portion.

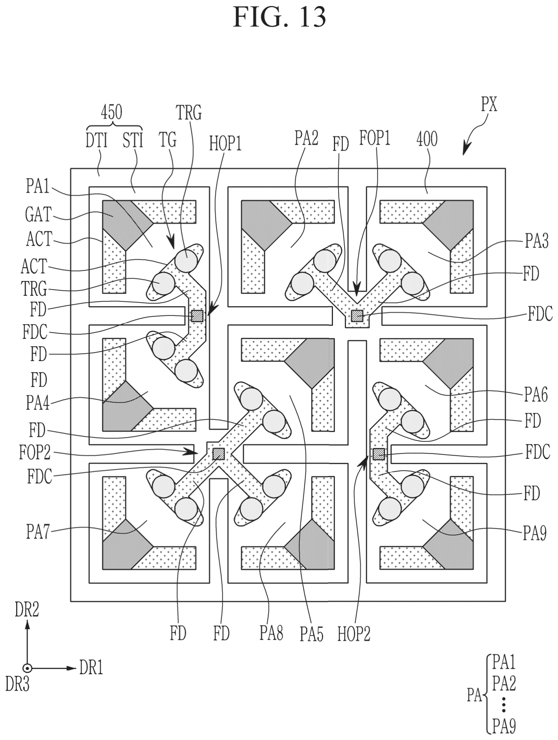

FIG. 13 illustrates the same or similar region as FIG. 12 with respect to some example embodiments. Referring to FIG. 13, the image sensor according to some example embodiments is identical to some example embodiments of FIG. 12 except for the arrangement of the fifth photoelectric conversion region PA5. Detailed description of the same component will be omitted. Referring to FIG. 13, the image sensor according to some example embodiments is the same or similar as that of FIG. 12 except that the floating diffusion region FD of the fifth photoelectric conversion region PA5 is connected to the second full open portion FOP2, not the first full open portion FOP1. A detailed description for the same component is omitted. Referring to FIG. 13, the floating diffusion region FD positioned in the first photoelectric conversion region PA1 and the fourth photoelectric conversion region PA4 in the first half open portion HOP1 may be connected as one. In addition, in the first full open portion FOP1, the floating diffusion region FD positioned in the second photoelectric conversion region PA2 and the third photoelectric conversion region PA3 may be connected as one. In the second full open portion FOP2, the floating diffusion region FD positioned in the fifth photoelectric conversion region PA5, the seventh photoelectric conversion region PA7, and the eighth photoelectric conversion region PA8 are connected as one, and in the second half open portion HOP2, the floating diffusion region FD of the sixth photoelectric conversion region PA6 and the ninth photoelectric conversion region PA9 may be connected as one. In some example embodiments of FIG. 13, the substrate 400 of the nine photoelectric conversion regions is connected as one, and the floating diffusion region FD of each photoelectric conversion region may be connected as one through four floating diffusion region connection patterns FDC. In addition, in one pixel PX, the deep trench isolation layer DTI is connected as one without an island-type separated portion.

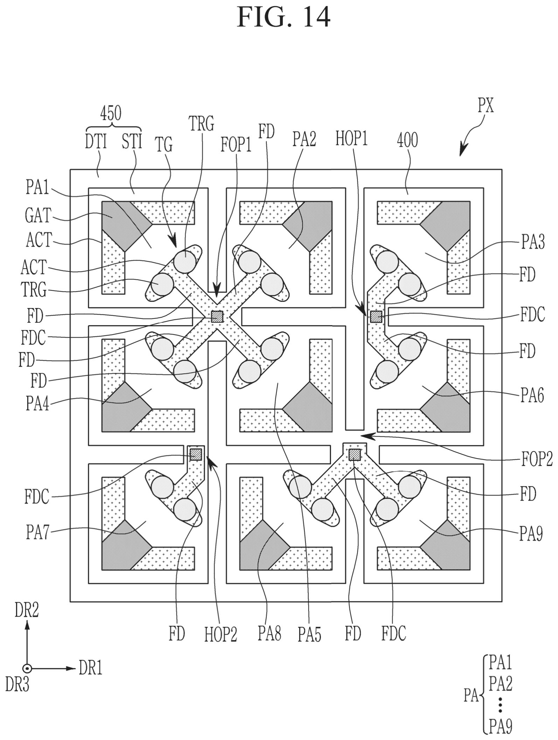

FIG. 14 illustrates the same or similar region as FIG. 6 for some example embodiments. Referring to FIG. 14, the image sensor according to some example embodiments is the same or similar as some example embodiments of FIG. 6 except for the shape of the fourth photoelectric conversion region PA4. Detailed description for the same component is omitted. Referring to FIG. 14, the floating diffusion region FD positioned in the fourth photoelectric conversion region PA4 may extend to the first full open portion FOP1. Therefore, referring to FIG. 14, in the first full open portion FOP1, the floating diffusion region FD of the first photoelectric conversion region PA1, the second photoelectric conversion region PA2, the fourth photoelectric conversion region PA4, and the fifth photoelectric conversion region PA5 may be connected as one. In addition, in the first half open portion HOP1, the floating diffusion region FD positioned in the third photoelectric conversion region PA3 and the sixth photoelectric conversion region PA6 may be connected as one. The second half open portion HOP2 is positioned such that the floating diffusion region FD positioned at the seventh photoelectric conversion region PA7 is positioned thereon, and, at the second full open portion FOP2, the floating diffusion region FD positioned at the eighth photoelectric conversion region PA8 and the ninth photoelectric conversion region PA9 may be connected as one.

That is, in the previous example, the floating diffusion regions FD of the nine photoelectric conversion regions were connected to the full open portions FOP1, FOP2 and half open portions HOP1, HOP2 in groups of 3/2/2/2, respectively, and the number of floating diffusion regions FD connected to each of the four floating diffusion region connection patterns FDC was 3/2/2/2, respectively. This is a structure corresponding to the circuit diagram of FIG. 2 described above.

However, in the case of some example embodiments of FIG. 14, the floating diffusion regions of nine photoelectric conversion regions may be connected to the full open portions FOP1, FOP2 and the half open portions HOP1, HOP2 in 4/2/1/2, respectively. That is, the number of floating diffusion regions connected to the four floating diffusion region connection patterns may be 4/2/1/2, respectively. This is a structure corresponding to the circuit diagram of FIG. 3 described above. In some example embodiments as well, it is the same that the floating diffusion regions FD of the nine photoelectric conversion regions PA are connected as one through the four floating diffusion region connection patterns FDC. That is, also in some example embodiments of FIG. 14, the substrate 400 of the nine photoelectric conversion regions is connected as one, and the floating diffusion region FD of each photoelectric conversion region may be connected as one through four floating diffusion region connection patterns FDC. In addition, in one pixel PX, the deep trench isolation layer DTI is connected as a single unit without an island-type separated portion.

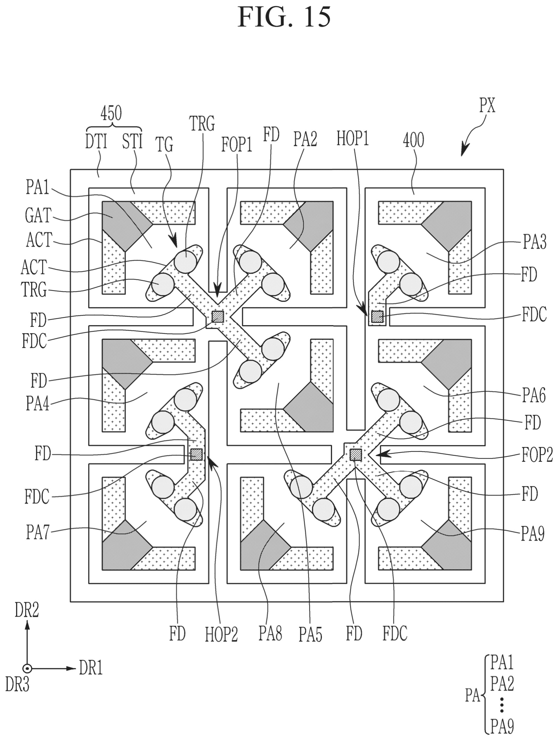

FIG. 15 illustrates the same or similar region as FIG. 6 with respect to some example embodiments. Referring to FIG. 15, the image sensor according to some example embodiments is the same or similar as FIG. 6 except for the shape of the sixth photoelectric conversion region PA6. Detailed description for the same component is omitted. Referring to FIG. 15, the floating diffusion region FD positioned in the sixth photoelectric conversion region PA6 may extend to the second full open portion FOP2.

Accordingly, as shown in FIG. 15, in the first full open portion FOP1, the floating diffusion regions FD of the first photoelectric conversion region PA1, the second photoelectric conversion region PA2, and the fifth photoelectric conversion region PA5 are connected into one, and in the first half open portion HOP1, the floating diffusion region FD of the third photoelectric conversion region PA3 may be extended. The second half open portion HOP2 is configured such that the floating diffusion region FD positioned in the fourth photoelectric conversion region PA4 and the seventh photoelectric conversion region PA7 are connected integrally, and in the second full open portion FOP2, the floating diffusion region FD positioned in the sixth photoelectric conversion region PA6, the eighth photoelectric conversion region PA8, and the ninth photoelectric conversion region PA9 may be connected integrally.

That is, in the case of some example embodiments of FIG. 15, the floating diffusion regions FD of the nine photoelectric conversion regions PA may be connected to the full open portions FOP1, FOP2 and the half open portions HOP1, HOP2 as 3/1/2/3, respectively. That is, the number of floating diffusion regions connected to the four floating diffusion region connection patterns FDC may be 3/1/2/3, respectively. This is a structure corresponding to the circuit diagram of FIG. 4 described above. In some example embodiments as well, it is the same that the floating diffusion regions FD of the nine photoelectric conversion regions PA are connected as one through the four floating diffusion region connection patterns FDC. That is, also in some example embodiments of FIG. 15, the substrate 400 of the nine photoelectric conversion regions is connected as one, and the floating diffusion region FD of each photoelectric conversion region may be connected as one through four floating diffusion region connection patterns FDC. In addition, in a single pixel PX, the deep trench isolation layer DTI is connected as one without any island-type separated portion.

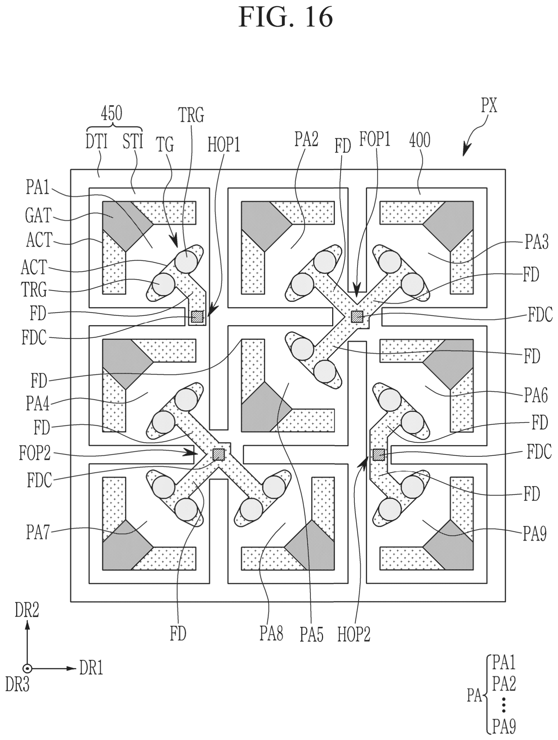

FIG. 16 illustrates the same or similar region as FIG. 15 with respect to some example embodiments. With reference to FIG. 16, the image sensor according to some example embodiments has positions of the first full open portion FOP1, the first half open portion HOP1, the second full open portion FOP2, and the second half open portion HOP2 that are different from those in FIG. 15. That is, in the case of FIG. 15, a first full open portion FOP1 is positioned at a corner where the first photoelectric conversion region PA1, the second photoelectric conversion region PA2, the fourth photoelectric conversion region PA4, and the fifth photoelectric conversion region PA5 meet, whereas in the case of FIG. 16, a first half open portion HOP1 may be positioned at a corner where the first photoelectric conversion region PA1, the second photoelectric conversion region PA2, the fourth photoelectric conversion region PA4, and the fifth photoelectric conversion region PA5 meet. Referring to FIG. 16, the floating diffusion region FD of the first photoelectric conversion region PA1 is extended to the first half open portion HOP1, and in the first full open portion FOP1, the floating diffusion region FD positioned in the second photoelectric conversion region PA2, the third photoelectric conversion region PA3, and the fifth photoelectric conversion region PA5 may be connected as one. In the second full open portion FOP2, the floating diffusion region FD positioned in the fourth photoelectric conversion region PA4, the seventh photoelectric conversion region PA7, and the eighth photoelectric conversion region PA8 is connected as one, and in the second half open portion HOP2, the floating diffusion region FD of the sixth photoelectric conversion region PA6 and the ninth photoelectric conversion region PA9 may be connected as one. That is, also in some example embodiments of FIG. 16, the substrate 400 of the nine photoelectric conversion regions is connected as one, and the floating diffusion region FD of each photoelectric conversion region PA may be connected as one through the four floating diffusion region connection patterns FDC. In addition, in one pixel PX, the deep trench isolation layer DTI is integrally connected without an island-type separated portion.

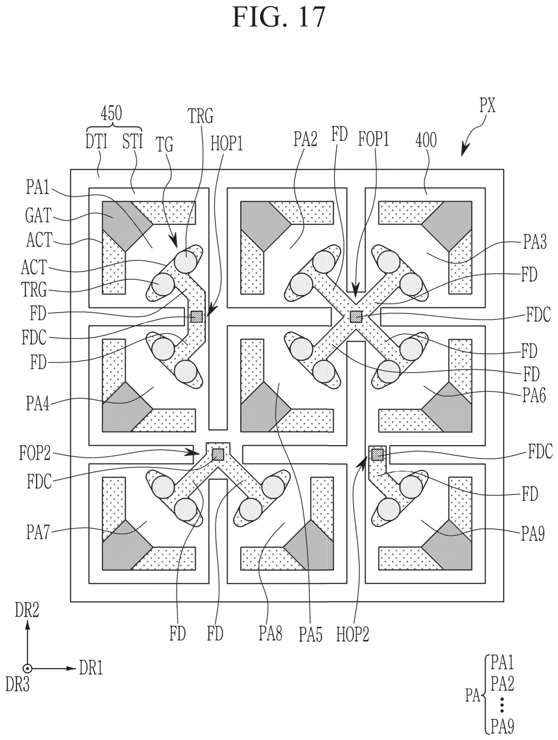

FIG. 17 illustrates the same or similar region as FIG. 12 with respect to some example embodiments. Referring to FIG. 17, the image sensor according to some example embodiments is identical to FIG. 12 except for the shape of the sixth photoelectric conversion region PA6. Detailed descriptions of the same component will be omitted. With reference to FIG. 17, the image sensor according to some example embodiments is such that the floating diffusion region of the sixth photoelectric conversion region PA6 is extended to the first full open portion FOP1. Therefore, as shown in FIG. 17, in the first half open portion HOP1, the floating diffusion region FD of the first photoelectric conversion region PA1 and the fourth photoelectric conversion region PA4 are connected as one, and in the first full open portion FOP1, the floating diffusion region FD positioned in the second photoelectric conversion region PA2, the third photoelectric conversion region PA3, the fifth photoelectric conversion region PA5, and the sixth photoelectric conversion region PA6 may be connected as one. In the second full open portion FOP2, the floating diffusion region FD positioned in the seventh photoelectric conversion region PA7 and the eighth photoelectric conversion region PA8 are connected as one, and in the second half open portion HOP2, the floating diffusion region FD of the ninth photoelectric conversion region PA9 may be extended.

Referring to FIG. 17, the floating diffusion region FD of the nine photoelectric conversion regions PA may be connected to the full open portion FOP1, FOP2 and the half open portion HOP1, HOP2 in numbers of four, two, one, and two, respectively. This is a structure corresponding to the circuit diagram of FIG. 3 described above. In some example embodiments as well, it is the same that the floating diffusion region FD of the nine photoelectric conversion regions PA is connected as one through the four floating diffusion region connection patterns FDC. That is, also in some example embodiments of FIG. 17, the substrate 400 of the nine photoelectric conversion regions PA is connected as one, and the floating diffusion region FD of each photoelectric conversion region PA may be connected as one through four floating diffusion region connection patterns FDC. In addition, in a single pixel PX, the deep trench isolation layer DTI is connected as one without an island-type separated portion.

In the above, some example embodiments in which the floating diffusion region connection pattern FDC is positioned in the full open portion FOP1, FOP2 and the half open portion HOP1, HOP2 of the separation pattern 450 has been described, but this is merely some example embodiments, and the floating diffusion region connection pattern FDC may not be positioned in the full open portion FOP1, FOP2 and the half open portion HOP1, HOP2 of the separation pattern 450. That is, the planar arrangement of each photoelectric conversion region PA is not limited to the above example embodiments. The ground voltage application pattern GND may be positioned on the full open portion FOP1, FOP2 and the half open portion HOP1, HOP2, or a separate pattern may not be positioned. Hereinafter, other example embodiments will be described.

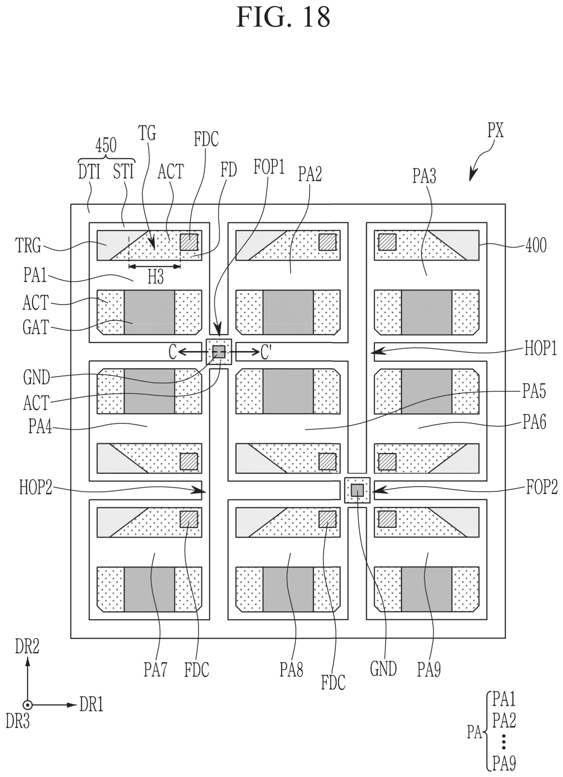

FIG. 18 illustrates the same or similar region as FIG. 6 with respect to some example embodiments. Referring to FIG. 18, the image sensor according to some example embodiments may be configured such that the floating diffusion region connection pattern FDC is not positioned in the first full open portion FOP1 and the second full open portion FOP2, and the ground voltage application pattern GND may be positioned therein. Hereinafter, a description will be given of the planar arrangement with respect to the first photoelectric conversion region PA1 of FIG. 18.

Referring to FIG. 18, the first photoelectric conversion region PA1 may include a plurality of active pattern ACT, and gate electrode GAT and transfer gate electrode TRG overlapping therewith. For example, the active pattern ACT and the transfer gate electrode TRG overlapping therewith may constitute the transfer transistor TG. A portion of the active pattern ACT of the transfer transistor TG constitutes the floating diffusion region FD, and the floating diffusion region connection pattern FDC may be positioned to overlap with the floating diffusion region FD. With reference to FIG. 18, a floating diffusion region connection pattern FDC may be positioned at each photoelectric conversion region PA, respectively. In FIG. 18, nine photoelectric conversion regions PA are included in one pixel PX, and a floating diffusion region connection pattern FDC may be positioned in each of the photoelectric conversion regions PA. Accordingly, one pixel PX may include nine floating diffusion region connection patterns FDC.

However, in some example embodiments, a ground voltage application pattern GND may be positioned in the first full open portion FOP1 and the second full open portion FOP2. As described above, the image sensor according to some example embodiments includes a separation pattern 450, for example, a deep trench isolation layer DTI including a full open portion FOP1, FOP2 and a half open portion HOP1, HOP2, and in a single pixel, the substrate 400 is connected as one (e.g., they may be integral). Therefore, by applying a ground voltage to the ground voltage application pattern GND shown in FIG. 18, a ground voltage may be applied to the entire substrate 400 of one pixel PX.

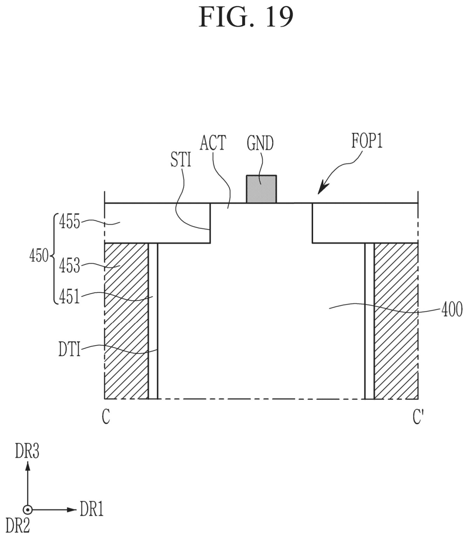

FIG. 19 is a cross-sectional view showing a cut taken along the C-C' line of FIG. 18. FIG. 19 illustrates only a portion of the region for convenience of explanation. Referring to FIG. 19, an active pattern ACT and a ground voltage application pattern GND may be positioned in the first full open portion FOP1. A ground voltage may be applied to the substrate 400 through the ground voltage application pattern GND. As shown in FIG. 18, the substrate 400 of one pixel PX through the full open portion FOP1, FOP2 and the half open portion HOP1, HOP2 is connected as one, so that a ground voltage may be applied to the entire substrate 400.

Referring to FIG. 18, since the ground voltage application pattern GND is positioned within the full open portion FOP1, FOP2, a space for the photoelectric conversion region PA may be secured. Therefore, the distance H3 between the transfer gate electrode TRG and the floating diffusion region connection pattern FDC may be increased, and the influence of the voltage change of the transfer gate electrode TRG on the floating diffusion region connection pattern FDC may be reduced.

With reference to FIG. 18 and FIG. 10 at the same time, in the case of FIG. 10 in which the separation pattern 450 does not include an open portion, the ground voltage application pattern GND is positioned at each photoelectric conversion region PA, so that the distance H2 between the transfer gate electrode TRG and the floating diffusion region connection pattern FDC was short. In comparison, in the case of FIG. 18, the ground voltage application pattern GND is not positioned at each photoelectric conversion region PA, so compared to FIG. 10, more space within the photoelectric conversion region PA may be secured. Therefore, as shown in FIG. 18, the distance H3 between the transfer gate electrode TRG and the floating diffusion region connection pattern FDC may be increased. When comparing FIG. 10 and FIG. 18, it can be confirmed that the distance H3 between the transfer gate electrode TRG and the floating diffusion region connection pattern FDC in FIG. 18 is longer than the distance H2 between the floating diffusion region connection patterns FDC in FIG. 10. In FIG. 18, the distance H3 between the gate electrode TRG and the floating diffusion region connection pattern FDC is also illustrated based on the center of the inclined surface of the transfer gate electrode TRG. However, this is merely some example embodiments and the present inventive concepts are not limited thereto. In FIG. 18, a configuration in which a ground voltage application pattern GND is positioned in each of a first full open portion FOP1 and a second full open portion FOP2 is illustrated; however, the ground voltage application pattern may be positioned in one of the first full open portion FOP1 and the second full open portion FOP2, or the ground voltage application pattern GND may be positioned in a region other than the first full open portion FOP1 and the second full open portion FOP2.

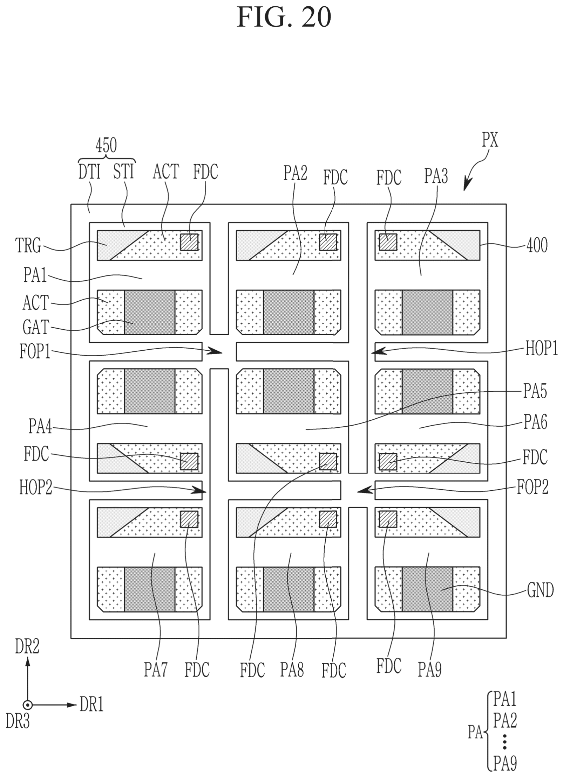

FIG. 20 illustrates the same or similar region as FIG. 18 with respect to some example embodiments. Referring to FIG. 20, the image sensor according to some example embodiments is identical to FIG. 18 except that the ground voltage application pattern is not positioned at the first full open portion FOP1 and the second full open portion FOP2. Detailed descriptions of the same component are omitted. Referring to FIG. 20, the ground voltage application pattern GND may be positioned within the photoelectric conversion region PA. In FIG. 20, some example embodiments in which the ground voltage application pattern GND is positioned in the ninth photoelectric conversion region PA9 is shown, but this is merely an example and the present inventive concepts are not limited thereto. As described above, in a single pixel PX, the substrate 400 is connected as one, and a ground voltage may be applied to the entire substrate 400 of the single pixel PX through the ground voltage application pattern GND positioned in the ninth photoelectric conversion region PA9.

In addition, although FIG. 18 and FIG. 20 illustrate a configuration in which each floating diffusion region FD positioned in each photoelectric conversion region includes a floating diffusion region connection pattern FDC, in some example embodiments, a floating diffusion region FD positioned in a portion of the photoelectric conversion regions may share a floating diffusion region connection pattern FDC.

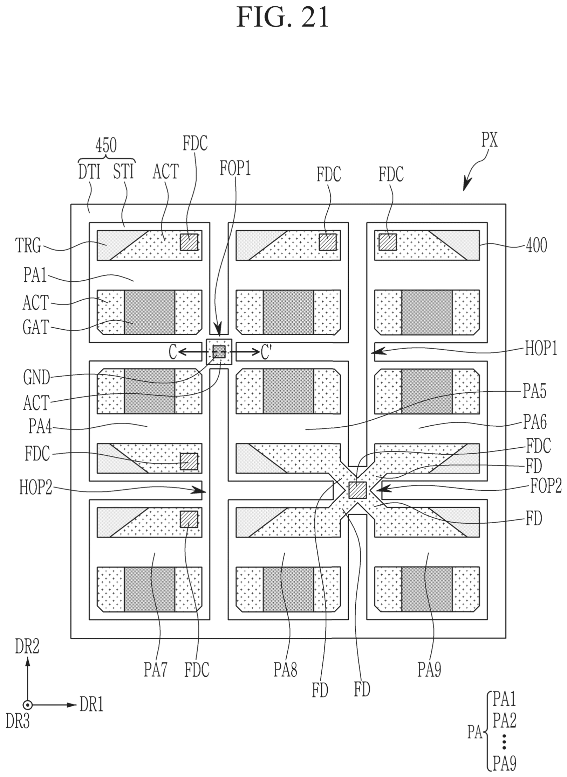

FIG. 21 illustrates the same or similar region as FIG. 20 with respect to some example embodiments. With reference to FIG. 21, the image sensor according to some example embodiments is identical to some example embodiments of FIG. 20 except that the floating diffusion region FD and the floating diffusion region connection pattern FDC are positioned in the second full open portion FOP2. Detailed descriptions of the same component will be omitted.

With reference to FIG. 21, the floating diffusion region FD positioned in the fifth photoelectric conversion region PA5, the sixth photoelectric conversion region PA6, the eighth photoelectric conversion region PA8, and the ninth photoelectric conversion region PA9 is extended to the second full open portion FOP2 and is integrally connected. Therefore, the fifth photoelectric conversion region PA5, the sixth photoelectric conversion region PA6, the eighth photoelectric conversion region PA8, and the ninth photoelectric conversion region PA9 may share a single floating diffusion region connection pattern FDC. Referring to FIG. 21, some example embodiments of FIG. 21 may include a single pixel having six floating diffusion region connection patterns FDC. Therefore, compared to FIG. 19 and FIG. 20 including nine floating diffusion region connection patterns FDC, nine floating diffusion regions FD may be more effectively connected.

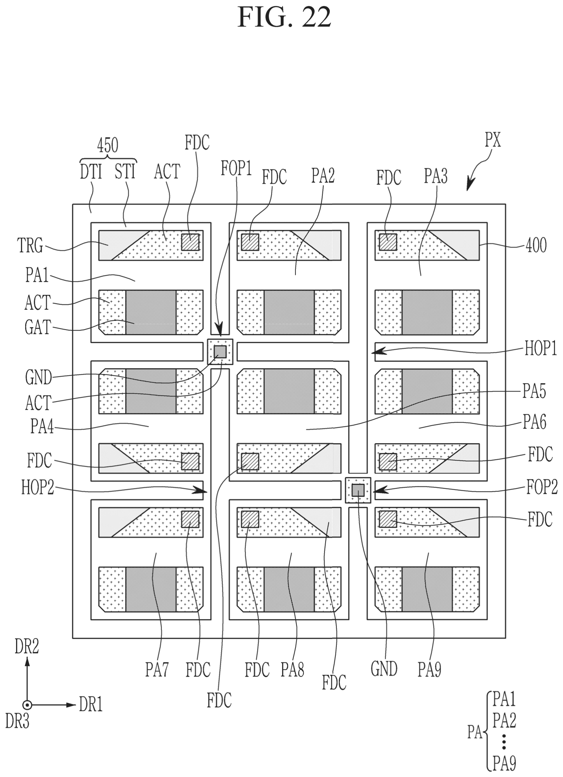

FIG. 22 illustrates the same or similar region as FIG. 18 with respect to some example embodiments. Referring to FIG. 22, the image sensor according to some example embodiments is the same or similar as that of FIG. 18 except for the arrangement of the second photoelectric conversion region PA2, the fifth photoelectric conversion region PA5, and the eighth photoelectric conversion region PA8. Detailed description of the same component will be omitted. In the case of some example embodiments of FIG. 22, the arrangement of the second photoelectric conversion region PA2, the fifth photoelectric conversion region PA5, and the eighth photoelectric conversion region PA8 of FIG. 18 may be parallel to the second direction DR2 and may have a shape that is laterally inverted about an imaginary straight line passing through the centers of the second photoelectric conversion region PA2, the fifth photoelectric conversion region PA5, and the eighth photoelectric conversion region PA8.

That is, in some example embodiments of FIG. 18, four floating diffusion region connection patterns FDC were positioned adjacent to the second full open portion FOP2, but in the case of FIG. 22, four floating diffusion region connection patterns FDC may be positioned adjacent to the second half open portion HOP2. In this manner, when the region in which a plurality of floating diffusion region connection patterns FDC are positioned is positioned far from the ground voltage application pattern GND, the connection wiring may be more effectively arranged.

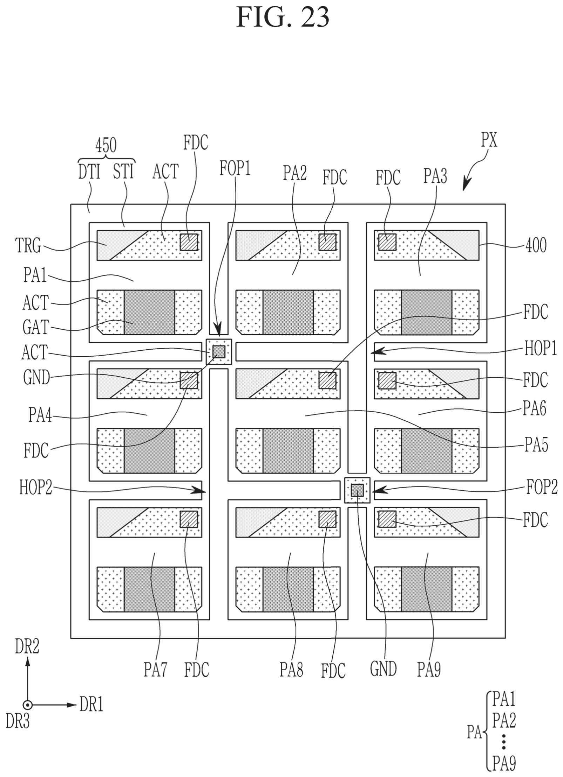

FIG. 23 shows the same or similar region as FIG. 18 with respect to some example embodiments. With reference to FIG. 23, the image sensor according to some example embodiments is identical to some example embodiments of FIG. 18 except for the arrangement of the fourth photoelectric conversion region PA4, the fifth photoelectric conversion region PA5, and the sixth photoelectric conversion region PA6. A detailed description for the same component is omitted. In the case of some example embodiments of FIG. 23, the arrangement of the fourth photoelectric conversion region PA4, the fifth photoelectric conversion region PA5, and the sixth photoelectric conversion region PA6 of FIG. 18 may be parallel to the first direction DR1, and may be an up-and-down inverted shape centered about an imaginary straight line passing through the centers of the fourth photoelectric conversion region PA4, the fifth photoelectric conversion region PA5, and the sixth photoelectric conversion region PA6.

That is, in some example embodiments of FIG. 18, four floating diffusion region connection patterns FDC were positioned adjacent to the second full open portion FOP2, but in the case of FIG. 23, two floating diffusion region connection patterns FDC may be positioned adjacent to the second full open portion FOP2. In the case of FIG. 23, each floating diffusion region connection pattern FDC may be dispersed and positioned around the first full open portion FOP1 and the second full open portion FOP2. In the case of having such an arrangement according to some example embodiments, the connection wiring may be more effectively arranged.

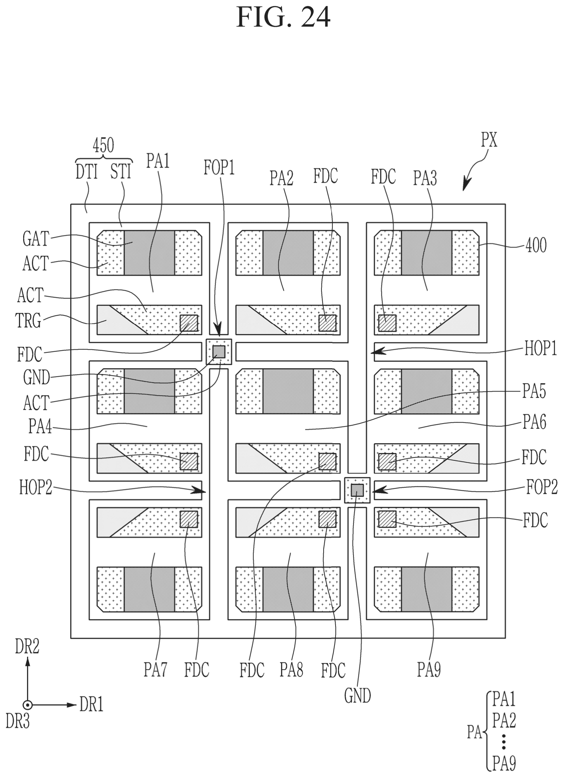

FIG. 24 illustrates the same or similar region as FIG. 18 with respect to some example embodiments. Referring to FIG. 24, the image sensor according to some example embodiments is identical to some example embodiments of FIG. 18 except for the arrangement of the first photoelectric conversion region PA1, the second photoelectric conversion region PA2, and the third photoelectric conversion region PA3. Detailed descriptions of the same component are omitted. In the case of some example embodiments of FIG. 23, the arrangement of the first photoelectric conversion region PA1, the second photoelectric conversion region PA2, and the third photoelectric conversion region PA3 of FIG. 18 may be parallel to the first direction DR1, and may have an up-down inverted shape with respect to a virtual straight line passing through the centers of the first photoelectric conversion region PA1, the second photoelectric conversion region PA2, and the third photoelectric conversion region PA3. Detailed description of the same component will be omitted.

Various modified examples may also be included. That is, the image sensor according to some example embodiments includes a deep trench isolation layer DTI of a separation pattern 450 included in a single pixel, the deep trench isolation layer DTI including two full open portions FOP1, FOP2 and two half open portions HOP1, HOP2, and if the deep trench isolation layer DTI of the separation pattern 450 included in a single pixel is connected as one, and the substrate 400 of the photoelectric conversion region PA included in a single pixel is connected as one structure, the planar arrangement is not limited to a specific shape. A single pixel may include nine photoelectric conversion regions.

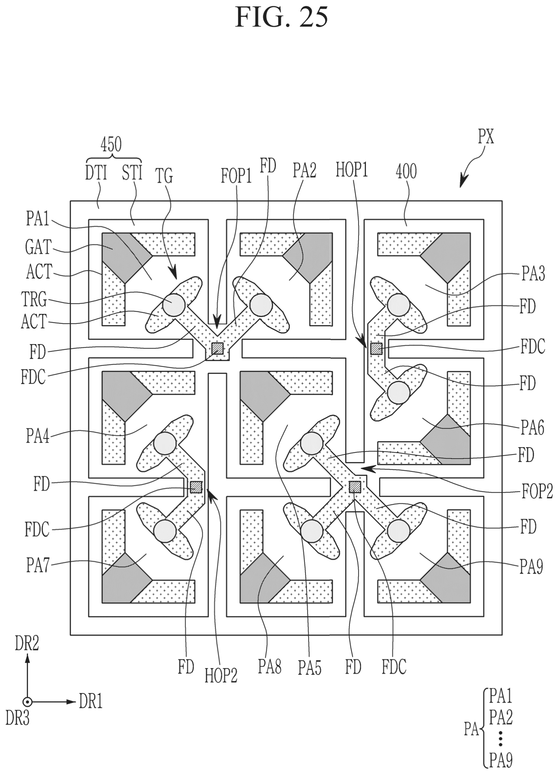

FIG. 25 illustrates the same or similar region as FIG. 6 with respect to some example embodiments. FIG. 25 is the same or similar as FIG. 6 except that the transfer transistor TG includes a single transfer gate electrode TRG. Detailed description of the same component will be omitted. That is, in some example embodiments, the transfer transistor TG may include a single transfer gate electrode TRG, and in addition, the planar arrangement may be various.

In the above-described embodiments, the first full open portion FOP1 and the second full open portion FOP2 are positioned in a region where four photoelectric conversion regions meet. However, in other example embodiments, three sub open portions may be positioned in a region where four photoelectric conversion regions meet. The three sub open portions may connect the four photoelectric conversion regions as one, in the same manner as the first full open portion FOP1 and the second full open portion FOP2.

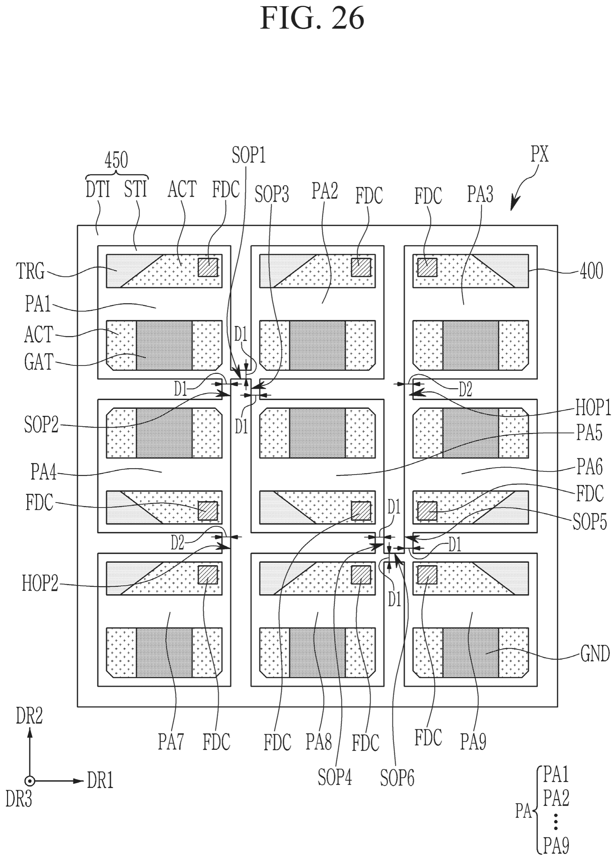

FIG. 26 illustrates the same or similar region as FIG. 20 according to other example embodiments. Referring to FIG. 26, the image sensor according to the present embodiment is the same as the embodiment of FIG. 20 except that a first sub open portion SOP1, a second sub open portion SOP2, and a third sub open portion SOP3 are positioned instead of the first full open portion FOP1, and a fourth sub open portion SOP4, a fifth sub open portion SOP5, and a sixth sub open portion SOP6 are positioned instead of the second full open portion FOP2. A detailed description of the same components will be omitted.

Referring to FIG. 26, the first sub open portion SOP1, the second sub open portion SOP2, and the third sub open portion SOP3 may be positioned in a region where the first photoelectric conversion region PA1, the second photoelectric conversion region PA2, the fourth photoelectric conversion region PA4, and the fifth photoelectric conversion region PA5 meet. The first sub open portion SOP1 may be positioned between the first photoelectric conversion region PA1 and the second photoelectric conversion region PA2. The second sub open portion SOP2 may be positioned between the first photoelectric conversion region PA1 and the fourth photoelectric conversion region PA4. The third sub open portion SOP3 may be positioned between the second photoelectric conversion region PA2 and the fifth photoelectric conversion region PA5. As illustrated in FIG. 26, through the first to third sub open portions SOP1, SOP2, and SOP3, the substrate 400 of the first photoelectric conversion region PA1, the second photoelectric conversion region PA2, the fourth photoelectric conversion region PA4, and the fifth photoelectric conversion region PA5 may be connected as one. That is, the first to third sub open portions SOP1, SOP2, and SOP3 may perform the same function as the first full open portion FOP1 of the previous embodiment.

A width D1 of each of the first to third sub open portions SOP1, SOP2, and SOP3 may be similar to a width D2 of the first half open portion. In the present specification, a width of an open portion refers to a width of a spaced region. In addition, in the present specification, the term "similar" means that a difference is within 20%. Accordingly, widths of the open portions within one pixel of the image sensor may be substantially similar to each other. When the widths of the open portions are similar, it is possible to prevent a problem in which sizes of respective depletion regions in the respective photoelectric conversion regions become different due to differences in open portion widths, resulting in different amounts of charge stored in the respective photoelectric conversion regions.

Similarly, referring to FIG. 26, the fourth sub open portion SOP4, the fifth sub open portion SOP5, and the sixth sub open portion SOP6 may be positioned in a region where the fifth photoelectric conversion region PA5, the sixth photoelectric conversion region PA6, the eighth photoelectric conversion region PA5, and the ninth photoelectric conversion region PA9 meet. The fourth sub open portion SOP4 may be positioned between the fifth photoelectric conversion region PA5 and the eighth photoelectric conversion region PA8. The fifth sub open portion SOP5 may be positioned between the sixth photoelectric conversion region PA6 and the ninth photoelectric conversion region PA9. The sixth sub open portion SOP6 may be positioned between the eighth photoelectric conversion region PA8 and the ninth photoelectric conversion region PA9. As illustrated in FIG. 26, through the fourth to sixth sub open portions SOP4, SOP5, and SOP6, the substrate 400 of the fifth photoelectric conversion region PA5, the sixth photoelectric conversion region PA6, the eighth photoelectric conversion region PA5, and the ninth photoelectric conversion region PA9 may be connected as one. That is, the fourth to sixth sub open portions SOP4, SOP5, and SOP6 may perform the same function as the second full open portion FOP2 of the previous embodiment.

Similarly, a width D1 of each of the fourth to sixth sub open portions SOP4, SOP5, and SOP6 may be similar to the width D2 of the first half open portion. Accordingly, widths of the open portions within one pixel may be substantially similar to each other. When the widths of the open portions within one pixel are similar, it is possible to prevent a problem in which amounts of charge stored in the respective photoelectric conversion regions become different due to differences in open portion widths. In the embodiment of FIG. 26 as well, the substrates 400 of the nine photoelectric conversion regions may be connected as one, and the deep trench isolation layer DTI of one pixel may be connected as one.

In the embodiment of FIG. 26, no separate active pattern may be positioned in the sub open portions and the half open portions. That is, as illustrated in FIG. 26, the ground voltage application pattern GND may be positioned within a photoelectric conversion region PA. Although FIG. 26 illustrates a configuration in which the ground voltage application pattern GND is positioned in the ninth photoelectric conversion region PA9, this is merely an example and is not limited thereto. Since the substrate 400 of one pixel PX is connected as one by the sub open portions SOP1 to SOP6 and the half open portions HOP1 and HOP2, a ground voltage may be applied to the entire substrate 400 of one pixel PX through the ground voltage application pattern GND positioned in the ninth photoelectric conversion region PA9.

As described above, the image sensor according to some example embodiments includes a single pixel including nine photoelectric conversion regions, and a separation pattern 450 included in the single pixel includes two full open portions and two half open portions, such that the substrate of the nine photoelectric conversion regions is connected as one and the deep trench isolation layer of the single pixel may be connected as one. Therefore, a ground voltage may be applied to the entire pixel region by a single ground voltage application pattern, and a negative bias may be applied to the deep trench isolation layer. In addition, the floating diffusion region of each photoelectric conversion region may extend to the two full open portions and the two half open portions, and a floating diffusion region connection pattern may be positioned thereon. The floating diffusion region may be more effectively connected through the floating diffusion region connection pattern, and the parasitic capacitance caused by the connection wiring may be reduced.

In addition, one pixel may include nine photoelectric conversion regions, and the separation pattern 450 included in one pixel may include six sub open portions and two half open portions, such that the substrates 400 of the nine photoelectric conversion regions are connected as one and the deep trench isolation layer DTI of one pixel is connected as one. Accordingly, a ground voltage may be applied to the entire pixel region with a single ground voltage application pattern, and a negative voltage may be applied to the deep trench isolation layer DTI.

In some example embodiments, an image sensor may include a pixel array configured to output a pixel signal, the pixel array including a substrate including photoelectric conversion regions, a separation pattern between the photoelectric conversion regions and a transfer transistor and a floating diffusion region at each of the photoelectric conversion regions, the separation pattern surrounding edges of nine of the photoelectric conversion regions in plan view to define a single pixel region, the separation pattern positioned in a first direction and a second direction crossing the first direction in plan view, within the single pixel region, the separation pattern including a first full open portion and a second full open portion, the separation pattern being spaced apart in both the first direction and the second direction, and including a first half open portion and a second half open portion, the separation pattern being spaced apart in one of the first direction and the second direction, and in at least one of the first full open portion, the second full open portion, the first half open portion, and the second half open portion, floating diffusion regions positioned at at least one of the photoelectric conversion regions are connected to each other, a readout circuit configured to convert the pixel signal generated by the pixel array into a pixel value, a data buffer configured to store the pixel value, and an image signal processor configured to perform image signal processing on the pixel values stored in the data buffer, and a controller configured to cause the image sensor to control the pixel array, the readout circuit, the ramp signal generator, the data buffer, and the image signal processor.

For example, the image sensor may further include a ramp signal generator configured to generate a reference signal, the readout circuit configured to compare the pixel signal and the reference signal to convert the pixel signal.

One or more of the elements disclosed above in FIG. 1 for example may include or be implemented in processing circuitry such as hardware including logic circuits; a hardware/software combination such as a processor executing software; or a combination thereof. For example, the processing circuitry may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, an application-specific integrated circuit (ASIC), etc.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

As used herein, expressions such as "one of," "one or more of," "any one of," "at least one of," and "at least one selected from" when preceding a list of elements, modify the entire list of elements and do not modify the individual elements of the list. Thus, for example, both "at least one of A, B, or C" and "at least one of A, B, and C" mean either A, B, C, or any combination thereof. Likewise, A and/or B means A, B, or A and B. While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

Any or all of the elements described with reference to the figures may communicate with any or all other elements described with reference to figures. For example, any element may engage in one-way and/or two-way and/or broadcast communication with any or all other elements in the figures, to transfer and/or exchange and/or receive information such as but not limited to data and/or commands, in a manner such as in a serial and/or parallel manner, via a bus such as a wireless and/or a wired bus (not illustrated). The information may be in encoded various formats, such as in an analog format and/or in a digital format.

## Claims

1. An image sensor (100) comprising:
a substrate (400) including photoelectric conversion regions (PA1-PA9);
a separation pattern (450) between the photoelectric conversion regions (PA1-PA9); and
a transfer transistor (TG) and a floating diffusion region (FD) at each of the photoelectric conversion regions (PA1-PA9),
the separation pattern surrounding edges of nine of the photoelectric conversion regions (PA1-PA9) in plan view to define a single pixel region (PX),
the separation pattern (450) extending in a first direction (DR1) and a second direction (DR2) crossing the first direction (DR1) in plan view,
within the single pixel region (PX), the separation pattern (450) including a first full open portion (FOP1) and a second full open portion (FOP2), in which the separation pattern (450) is spaced apart in both the first direction (DR1) and the second direction (DR2), and including a first half open portion (HOP1) and a second half open portion (HOP2), in which the separation pattern (450) is spaced apart in one of the first direction (DR1) and the second direction (DR2), and
in at least one of the first full open portion (FOP1), the second full open portion (FOP2), the first half open portion (HOP1), and the second half open portion (HOP2), floating diffusion regions (FD) at at least one of the photoelectric conversion regions (PA1-PA9) are connected to each other.

2. The image sensor (100) of claim 1, wherein, in the single pixel region (PX), the substrate (400) of the nine of the photoelectric conversion regions (PA1-PA9) is connected as one.

3. The image sensor (100) of claim 1 or 2, wherein
the separation pattern (450) includes a deep trench isolation layer (DTI) and a shallow trench isolation layer (STI), and
the deep trench isolation layer (DTI) included in the single pixel region (PX) is integrally connected.

4. The image sensor (100) of claim 3, wherein the first full open portion (FOP1), the second full open portion (FOP2), the first half open portion (HOP1), and the second half open portion (HOP2) are at points where the deep trench isolation layer (DTI) of the separation pattern intersects the first direction (DR1) and the second direction (DR2).

5. The image sensor (100) of any one of claims 1 to 4, wherein
the first full open portion (FOP1) and the second full open portion (FOP2) are not in parallel in the first direction (DR1) in plan view, and
the first full open portion (FOP1) and the second full open portion (FOP2) are not in parallel in the second direction (DR2) in plan view.

6. The image sensor (100) of any one of claims 1 to 5, wherein
the first half open portion (HOP1) and the second half open portion (HOP2) are not in parallel with the first direction (DR1) in plan view, and
the first half open portion (HOP1) and the second half open portion (HOP2) are not in parallel with the second direction (DR2) in plan view.

7. The image sensor (100) of any one of claims 1 to 6, wherein a floating diffusion region (FD) and a floating diffusion region connection pattern (FDC) overlapping therewith are in the first full open portion (FOP1), the second full open portion (FOP2), the first half open portion (HOP1), and the second half open portion (HOP2).

8. The image sensor (100) of claim 7, wherein a number of floating diffusion region connection patterns (FDC) included in the single pixel region (PX) is less than a number of photoelectric conversion regions (PA1-PA9) included in the single pixel region (PX).

9. The image sensor (100) of any one of claims 1 to 8, wherein
the floating diffusion regions (FD) of three photoelectric conversion regions (PA1-PA9) of the photoelectric conversion regions (PA1-PA9) are connected to the first full open portion (FOP1),
the floating diffusion regions (FD) of two photoelectric conversion regions (PA1-PA9) of the photoelectric conversion regions (PA1-PA9) are connected to the second full open portion (FOP2),
the floating diffusion regions (FD) of two photoelectric conversion regions (PA1-PA9) of the photoelectric conversion regions (PA1-PA9) are connected to the first half open portion (HOP1), and
the floating diffusion regions (FD) of two photoelectric conversion regions (PA1-PA9) of the photoelectric conversion regions (PA1-PA9) are connected to the second half open portion (HOP2).

10. The image sensor (100) of any one of claims 1 to 9, wherein
four of the floating diffusion regions (FD) of the photoelectric conversion regions (PA1-PA9) are connected to the first full open portion (FOP1),
two of the floating diffusion regions (FD) of the photoelectric conversion regions (PA1-PA9) are connected to the second full open portion (FOP2),
two of the floating diffusion regions (FD) of the photoelectric conversion regions (PA1-PA9) are connected to the first half open portion (HOP1), and
one of the floating diffusion regions (FD) of the photoelectric conversion regions (PA1-PA9) is connected to the second half open portion (HOP2).

11. The image sensor (100) of any one of claims 1 to 9, wherein
three of the floating diffusion regions (FD) of the photoelectric conversion regions (PA1-PA9) are connected to the first full open portion (FOP1),
three of the floating diffusion regions (FD) of the photoelectric conversion regions (PA1-PA9) are connected to the second full open portion (FOP2),
one of the floating diffusion regions (FD) of the photoelectric conversion regions (PA1-PA9) is connected to the first half open portion (HOP1), and
two of the floating diffusion regions (FD) of the photoelectric conversion regions (PA1-PA9) are connected to the second half open portion (HOP2).

12. The image sensor (100) of any one of claims 1 to 11, further comprising:
a ground voltage application pattern (GND) at one or more of the first full open portion or the second full open portion (FOP2).

13. The image sensor (100) of claim 12, wherein a number of ground voltage application patterns (GND) included in the single pixel region (PX) is less than a number of photoelectric conversion regions (PA1-PA9) included in the single pixel region (PX).
